# EUROPEAN PATENT APPLICATION

(11) **EP 4 535 082 A2**
(43) Date of publication of application: **09.04.2025**
(21) Application number: 24202276.2
(22) Date of filing: 24.09.2024
(51) Int. Cl.: G03F 7/09, G03F 7/40

(54) **COMPOSITION FOR FORMING METAL-CONTAINING FILM AND PATTERNING PROCESS**

(30) Priority: 04.10.2023 JP 2023172980
(71) Applicant: Shin-Etsu Chemical Co., Ltd., Tokyo 100-0005 (JP)
(72) Inventor: Kobayashi, Naoki, Niigata (JP); Ishiwata, Kenta, Niigata (JP); Kori, Daisuke, Niigata (JP); Nagamachi, Nobuhiro, Niigata, Niigata (JP)
(74) Representative: Sonnenhauser, Thomas Martin

(57) **Abstract**

The present invention is a composition for forming a metal-containing film, containing: (A) a metal compound containing at least one kind of metal selected from the group consisting of Ti, Zr, and Hf; (B) a crosslinking agent containing, per molecule, 2 or more and 4 or fewer cyclic ether structures having 2 to 13 carbon atoms; and (C) a solvent. This can provide: a composition for forming a metal-containing film having better dry etching resistance than conventional organic underlayer film materials and also having high filling and planarizing properties; and a patterning process in which the composition is used.

## Description

### TECHNICAL FIELD

The present invention relates to: a composition for forming a metal-containing film, usable for fine patterning according to a multilayer resist method in a semiconductor device manufacturing process; and a patterning process using the composition.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

On the other hand, in recent years, with the rapid miniaturization of DRAM memory, there is a growing need for further improvement in dry etching resistance, as well as a need for a resist underlayer film having excellent filling and planarizing properties. As a coating-type resist underlayer film (organic film) composition excellent in filling and planarizing properties, for example, the composition disclosed in Patent Document 2 has been reported. However, in view of application of this composition in the advanced generation, there is a concern about dry etching resistance. The application limit of the conventional coating-type resist underlayer film compositions is thus approaching.

To solve the problems, there is consideration of the development of the use of a material containing a metal element for a resist underlayer film. Patent Document 3 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 3, a metal oxide compound generally undergoes great thermal shrinkage during baking and induces remarkable degradation of filling after baking at a high temperature. Therefore, there is a concern that such a compound is insufficient as a resist underlayer film material for which high planarizing and filling properties and heat resistance are required. Patent Documents 4 and 5 report that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases).

### CITATION LIST

### PATENT LITERATURE

Patent Document 1: JP2004-205685A
Patent Document 2: JP6714493B2
Patent Document 3: JP6189758B2
Patent Document 4: JP6786391B2
Patent Document 5: JP7050137B2

### SUMMARY OF INVENTION

### TECHNICAL PROBLEM

The present invention has been made in view of the above-described circumstances. An object of the present invention is to provide: a composition for forming a metal-containing film having better dry etching resistance than conventional organic underlayer film materials and also having high filling and planarizing properties; and a patterning process in which the composition is used as a resist underlayer film material or the like.

### SOLUTION TO PROBLEM

To achieve the object, the present invention provides a composition for forming a metal-containing film, comprising:
(A) a metal compound containing at least one kind of metal selected from the group consisting of Ti, Zr, and Hf;
(B) a crosslinking agent containing, per molecule, 2 or more and 4 or fewer cyclic ether structures having 2 to 13 carbon atoms; and
(C) a solvent.

Such a composition for forming a metal-containing film can suppress thermal shrinkage of the metal compound during baking by the reaction between the metal compound and the crosslinking agent, and therefore, can provide a metal-containing film (resist underlayer film) excellent in filling property.

The crosslinking agent (B) preferably has two or more epoxy groups or oxetanyl groups per molecule.

Such a crosslinking agent has improved reactivity with the metal compound, and therefore, can provide a resist underlayer film having better filling property.

The crosslinking agent (B) is preferably one of organic compounds represented by the following formulae (1), 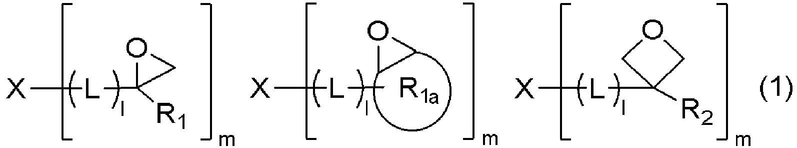 wherein X represents an m-valent organic group having 1 to 50 carbon atoms; L represents a carbonyl group or a divalent organic group having 1 to 10 carbon atoms; R₁ and R₂ each independently represent a hydrogen atom, a hydroxy group, an alkyl group having 1 to 10 carbon atoms, an aryl group having 6 to 10 carbon atoms, or an alkoxy group having 1 to 10 carbon atoms; R₁ₐ represents an alicyclic hydrocarbon group having 3 to 10 carbon atoms; "l" represents 0 or 1; and "m" represents 2 to 4.

Such a crosslinking agent has further improved reactivity with the metal compound, and therefore, can provide a resist underlayer film having even better filling property.

The X in the formulae (1) is preferably an m-valent organic group containing one or more of a quaternary carbon atom, an aromatic ring, an alicyclic hydrocarbon, or a heterocycle.

Such a crosslinking agent has excellent heat resistance, and therefore, the reaction with the metal compound during baking is promoted, so that the filling property of the composition for forming a metal-containing film can be further improved.

The X in the formulae (1) is preferably one of the following structures, 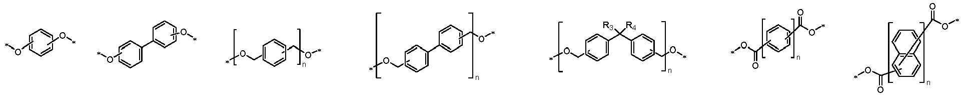 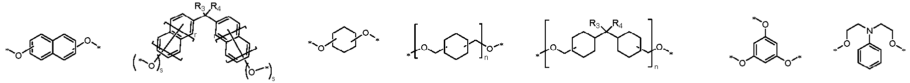 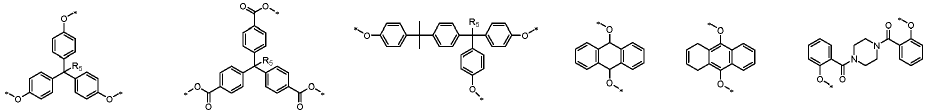 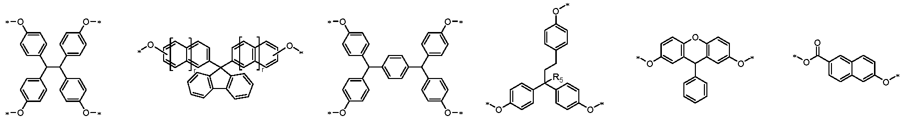 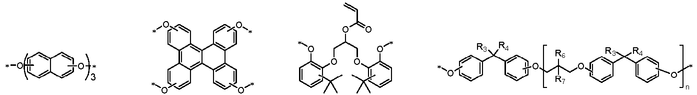 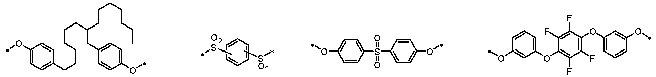 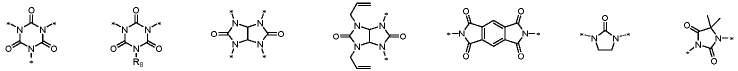 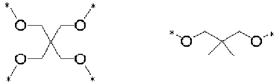 wherein "n" represents 1 to 5; "r" represents 0 or 1; "s" represents 1 or 2; R₃ and R₄ each independently represent a hydrogen atom or an alkyl group having 1 to 10 carbon atoms and optionally containing a halogen atom; R₅ represents a hydrogen atom, a hydroxy group, or an alkyl group having 1 to 10 carbon atoms; R₆ and R₇ each independently represent a hydrogen atom, a hydroxy group, or an organic group containing a group having 1 to 10 carbon atoms selected from alkyl, alkylene, and alkynyl; R₈ represents a hydrogen atom, a hydroxy group, or an organic group containing a group having 1 to 10 carbon atoms selected from alkyl, alkylene, and alkynyl; "*" represents an attachment point to the L; and a carbon atom in an aromatic ring in the formulae optionally has a substituent selected from a hydroxy group, a carboxy group, an ethenyl group, an ethynyl group, an amino group, a sulfide group, and an alkyl group having 1 to 10 carbon atoms optionally including the groups.

Such a crosslinking agent has excellent thermal flowability and heat resistance, and therefore, can further improve the filling property of the composition for forming a metal-containing film.

The metal compound (A) is preferably derived from a metal compound represented by the following formula (2),

LnₐMXn_{b} (2)

wherein M represents any of Ti, Zr, and Hf; Ln independently represents a monodentate ligand having 1 to 30 carbon atoms or a polydentate ligand having 1 to 30 carbon atoms; Xn independently represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.

When such a metal compound is contained, it is possible to form a composition for forming a metal-containing film that exhibits excellent resistance to dry etching using oxygen gas and fluorine gas.

The formula (2) preferably has a structure of the following formula (3),

M(OR^{1A})₄ (3)

wherein M represents Ti, Zr, or Hf; and R^{1A} represents a monovalent organic group having 1 to 20 carbon atoms.

A metal compound having such a structure is preferable from the viewpoints of productivity and the availability of raw materials.

The metal compound (A) is preferably a reaction product between: a compound derived from the metal compound represented by the formula (2); and an organic compound having 1 to 30 carbon atoms and containing at least one crosslinking group represented by any of the following general formulae (a-1) to (a-4), (b-1) to (b-4), (c-1) to (c-3), (d-1), and (d-2), 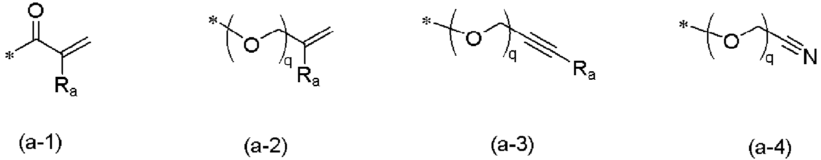 wherein Rₐ independently represents a hydrogen atom or a monovalent organic group having 1 to 10 carbon atoms, "q" represents 0 or 1, and "*" represents an attachment point, 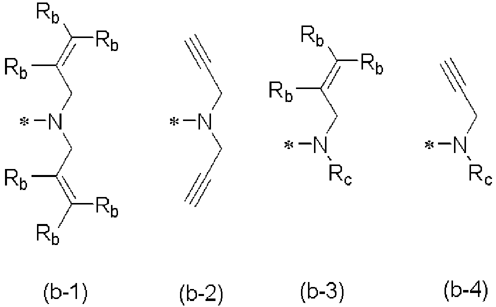 wherein R_{b}s each independently represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 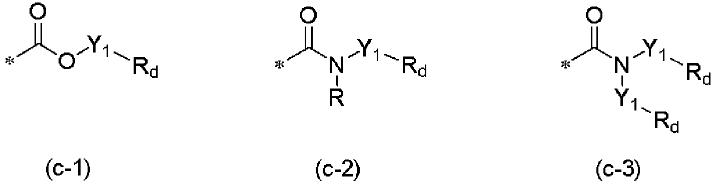 wherein Y₁ independently represents a divalent organic group having 1 to 20 carbon atoms, R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms, R_{d} independently represents an organic group whose protecting group is to be removed by an action of an acid, heat, or both to generate one or more hydroxy groups or carboxyl groups, R_{d} being represented by one of the following general formulae (c-4), and "*" represents an attachment point, 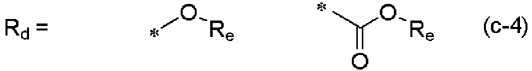 wherein Rₑ represents an organic group whose protecting group is to be removed by an action of an acid, heat, or both, and "*" represents an attachment point to Y₁, 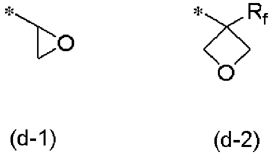 wherein R_{f} represents a hydrogen atom or an organic group having 1 to 10 carbon atoms, and "*" represents an attachment point.

When such a crosslinking group is contained, the reactivity with the crosslinking agent is improved, and volume shrinkage at the time of baking can be further alleviated. Therefore, it is possible to provide a composition for forming a metal-containing film having excellent planarizing and filling properties even after high-temperature baking.

The crosslinking agent (B) is preferably contained in an amount of 5 to 100 parts by mass based on 100 parts by mass of the metal compound (A).

When the contained amount is as described, it is possible to provide a metal-containing film that is excellent in the property of filling a stepped substrate and hardly outgases during baking.

The solvent (C) is preferably a mixture of one or more kinds of organic solvent having a boiling point of lower than 180°C and one or more kinds of organic solvent having a boiling point of 180°C or higher.

When such a high-boiling-point solvent is contained, it is possible to suppress the self-crosslinking of the metal compound that causes the generation of voids, and since the coexisting solvents contribute to the enhancement of the thermal flowability of the composition for forming a metal-containing film and to the reduction of dryness-induced defects at the time of film formation, a suitable metal-containing film can be formed. Note that, in the present description, the boiling point is the value at a pressure of 1 atmosphere (1013 hPa).

In addition, the present invention provides a patterning process for forming a pattern in a substrate to be processed, comprising the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask;
   and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) forming a resist underlayer film on a substrate to be processed;
(II-2) applying the above-described composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed.

The patterning process by way of the three-layer resist process makes it possible to form fine patterns on the body to be processed with high accuracy.

As described above, in the present invention, a metal-containing film may be formed directly on the substrate to be processed as a resist underlayer film by using the above-described composition for forming a metal-containing film, or a resist underlayer film may be formed on the substrate to be processed and then a metal-containing film may be formed separately by using the above-described composition for forming a metal-containing film.

The present invention also provides a patterning process for forming a pattern in a substrate to be processed, comprising the steps of:
(III-1) applying the above-described composition for forming a metal-containing film onto a substrate to be processed, followed by heating to form a metal-containing film;
(III-2) forming a silicon-containing resist middle layer film on the metal-containing film;
(III-3) forming a resist upper layer film on the silicon-containing resist middle layer film by using a photoresist material;
(III-4) subjecting the resist upper layer film to pattern exposure and then development with a developer to form a pattern in the resist upper layer film;
(III-5) transferring the pattern to the silicon-containing resist middle layer film by dry etching while using the resist upper layer film having the formed pattern as a mask;
(III-6) transferring the pattern to the metal-containing film by dry etching while using the silicon-containing resist middle layer film having the transferred pattern as a mask; and
(III-7) processing the substrate to be processed while using the metal-containing film having the formed pattern as a mask to form the pattern in the substrate to be processed.

The patterning process by way of the three-layer resist process makes it possible to form fine patterns on the body to be processed with high accuracy.

The present invention also provides a patterning process for forming a pattern in a substrate to be processed, comprising the steps of:
(IV-1) applying the above-described composition for forming a metal-containing film onto a substrate to be processed, followed by heating to form a metal-containing film;
(IV-2) forming an inorganic hard mask middle layer film selected from a silicon oxide film, a silicon nitride film, and a silicon oxynitride film on the metal-containing film;
(IV-3) forming an organic thin film on the inorganic hard mask middle layer film;
(IV-4) forming a resist upper layer film on the organic thin film by using a photoresist material;
(IV-5) subjecting the resist upper layer film to pattern exposure and then development with a developer to form a pattern in the resist upper layer film;
(IV-6) transferring the pattern to the organic thin film and the inorganic hard mask middle layer film by dry etching while using the resist upper layer film having the formed pattern as a mask;
(IV-7) transferring the pattern to the metal-containing film by dry etching while using the inorganic hard mask middle layer film having the transferred pattern as a mask; and
(IV-8) processing the substrate to be processed while using the metal-containing film having the formed pattern as a mask to form the pattern in the substrate to be processed.

The patterning process by way of the four-layer resist process makes it possible to form fine patterns on the body to be processed with high accuracy.

In this event, the inorganic hard mask middle layer film is preferably formed by a CVD method or an ALD method.

When the inorganic hard mask is formed by a CVD method or an ALD method, a fine pattern can be formed on a body to be processed with higher accuracy.

The present invention also provides a patterning process for forming a pattern in a substrate to be processed, comprising the steps of:
(V-1) applying the above-described composition for forming a metal-containing film onto a substrate to be processed, followed by heating to form a metal-containing film;
(V-2) forming an organic middle layer film on the metal-containing film;
(V-3) forming a silicon-containing resist middle layer film or a combination of an organic thin film and an inorganic hard mask middle layer film selected from a silicon oxide film, a silicon nitride film, and a silicon oxynitride film on the organic middle layer film;
(V-4) forming a resist upper layer film on the silicon-containing resist middle layer film or the organic thin film by using a photoresist material;
(V-5) subjecting the resist upper layer film to pattern exposure and then development with a developer to form a pattern in the resist upper layer film;
(V-6) transferring the pattern to the silicon-containing resist middle layer film or the organic thin film and the inorganic hard mask middle layer film by dry etching while using the resist upper layer film having the formed pattern as a mask;
(V-7) transferring the pattern to the organic middle layer film by dry etching while using the silicon-containing resist middle layer film or the inorganic hard mask middle layer film having the transferred pattern as a mask;
(V-8) transferring the pattern to the metal-containing film by dry etching while using the organic middle layer film as a mask; and
(V-9) processing the substrate to be processed while using the metal-containing film having the formed pattern as a mask to form the pattern in the substrate to be processed.

The patterning process by way of the multilayer resist process makes it possible to form fine patterns on the body to be processed with high accuracy.

The present invention also provides a tone-reversal patterning process for forming a pattern in a substrate to be processed, comprising the steps of:
(VI-1) forming a resist underlayer film on a substrate to be processed;
(VI-2) forming a silicon-containing resist middle layer film or a combination of an organic thin film and an inorganic hard mask middle layer film selected from a silicon oxide film, a silicon nitride film, and a silicon oxynitride film on the resist underlayer film;
(VI-3) forming a resist upper layer film on the silicon-containing resist middle layer film or the combination of the inorganic hard mask middle layer film and the organic thin film by using a photoresist material;
(VI-4) subjecting the resist upper layer film to pattern exposure and then development with a developer to form a pattern in the resist upper layer film;
(VI-5) transferring the pattern to the silicon-containing resist middle layer film or the organic thin film and the inorganic hard mask middle layer film by dry etching while using the resist upper layer film having the formed pattern as a mask;
(VI-6) transferring the pattern to the resist underlayer film by dry etching while using the silicon-containing resist middle layer film or the inorganic hard mask middle layer film having the transferred pattern as a mask;
(VI-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(VI-8) etching back the metal-containing film covering the resist underlayer film having the formed pattern by a chemical stripper or dry etching to expose an upper surface of the resist underlayer film having the formed pattern;
(VI-9) removing the silicon-containing resist middle layer film or the inorganic hard mask middle layer film remaining on the upper surface of the resist underlayer film by dry etching;
(VI-10) removing, by dry etching, the resist underlayer film having the formed pattern with an exposed surface to form a reverse pattern of an original pattern on the metal-containing film; and
(VI-11) processing the substrate to be processed while using the metal-containing film having the formed reverse pattern as a mask to form the reverse pattern in the substrate to be processed.

The patterning process by way of the reverse process makes it possible to form fine patterns on the body to be processed with even higher accuracy.

### ADVANTAGEOUS EFFECTS OF INVENTION

As described above, the inventive composition for forming a metal-containing film contains: (A) a metal compound, (B) a crosslinking agent containing, per molecule, 2 or more and 4 or fewer cyclic ether structures having 2 to 13 carbon atoms; and (C) a solvent. The volume shrinkage of the metal compound, which is the main cause of voids, can be alleviated by the reaction between the metal compound (A) and the crosslinking agent (B), and therefore, it is possible to provide a resist underlayer film material that has excellent planarizing and filling properties even after high-temperature baking.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive composition has better dry etching resistance than conventional coating-type resist underlayer film materials, and therefore, a fine pattern can be formed on a body to be processed with even higher precision compared with a resist underlayer film.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating filling property.

### DESCRIPTION OF EMBODIMENTS

As stated above, there have been demands for the development of: a composition for forming a metal-containing film, excellent in filling property and planarization property, used for forming a resist underlayer film that makes it possible to transfer a resist pattern to a substrate to be processed with higher precision in a fine patterning process according to a multilayer resist method; and a patterning process using the composition.

The present inventors have focused on metal materials that exhibit better etching resistance than conventional resist underlayer film materials and studied earnestly. On the other hand, conventional metal compounds for forming a resist underlayer film have poor heat resistance, and undergo sudden volume shrinkage during baking, and therefore, it is difficult to fill and planarize the steps of a substrate to be processed after high-temperature baking. Accordingly, the present inventors have hypothesized that it may be possible to suppress the volume shrinkage of a metal compound during baking by using an additive.

As a polyfunctional organic compound used in a composition for forming a metal-containing film, for example, it is reported that a nitrogen-containing organic compound having two or more hydroxy groups contributes to the stability of a metal compound in a composition (WO2020/241712A1). It is also reported that polyols serve as filling property aids (JP6810696B2). These additives have hydroxy groups, and therefore, in the state of a composition for forming a metal-containing film, are conjectured to be coordinated to a metal atom or in a free state, and are volatilized or thermally decomposed during baking. Therefore, it is expected that the additives have little effect of improving filling property. JP6810696B2 reports that the addition of a polyol improves filling property, but this is the result of baking at 250°C, and there is no discussion of filling property at a higher temperature, which is necessary for forming a metal oxide film.

The present inventors have considered that by a polyfunctional organic compound reacting with a metal compound at the time of baking and not being coordinated to the metal in the state of a composition for forming a metal oxide film, rapid volume shrinkage of a metal compound can be suppressed, and it is possible to fill the steps of a substrate to be processed without the generation of voids even after high-temperature baking.

The present inventors have further studied earnestly and found out that when the polyfunctional crosslinking group has a cyclic ether structure having 2 to 13 carbon atoms, reactivity with the metal compound at the time of baking can be enhanced without the stability of the composition for forming a metal-containing film being degraded, and it is possible to form a metal-containing film excellent in filling property. Thus, the present invention has been completed.

That is, the present invention is a composition for forming a metal-containing film, comprising:
(A) a metal compound containing at least one kind of metal selected from the group consisting of Ti, Zr, and Hf;
(B) a crosslinking agent containing, per molecule, 2 or more and 4 or fewer cyclic ether structures having 2 to 13 carbon atoms; and
(C) a solvent.

Hereinafter, the present invention will be described in detail, but the present invention is not limited thereto.

### <Composition for Forming Metal-Containing Film>

The inventive composition for forming a metal-containing film contains:
(A) a metal compound containing at least one kind of metal selected from the group consisting of Ti, Zr, and Hf;
(B) a crosslinking agent containing, per molecule, 2 or more and 4 or fewer cyclic ether structures having 2 to 13 carbon atoms; and
(C) a solvent.

The metal compound (A) (hereinafter, also referred to as "the compound for forming a metal-containing film") can be contained in a composition for forming a metal-containing film used in manufacturing a semiconductor, for example.

Note that in the inventive composition for forming a metal-containing film, one kind of each of the metal compound (A), the crosslinking agent (B), and the solvent (C) may be used, or two or more kinds may be used in combination. Furthermore, the composition for forming a metal-containing film may contain components other than the components (A), (B), and (C). In the following, each component will be described.

### <Metal Compound>

The metal compound contained in the inventive composition for forming a metal-containing film contains at least one kind of metal atom selected from the group consisting of Ti, Zr, and Hf, and is preferably a compound having a metal-oxygen covalent bond.

When such a metal is contained, it is possible to increase the refractive index of a heat-treated metal-containing film, and it is also possible to form a metal-containing film having excellent resistance to dry etching using an oxygen gas and a fluorine gas.

The proportion of the metal element atom contained in the metal compound (A) preferably has a lower limit of 5 mass%, more preferably 10 mass%, further preferably 20 mass%, and particularly preferably 30 mass%. The upper limit of the contained proportion is preferably 50 mass%. The proportion of the metal element atom contained can be determined by measurement using a thermogravimetry/differential thermal analyzer (TG/DTA).

When the proportion of the metal element is as described, it is possible to enhance further the refractive index of the composition for forming a metal-containing film and dry etching resistance to oxygen gas and fluorine gas.

The metal atom contained in the metal compound may consist of atoms of one element or two or more elements, but in view of the fact that the etching rate when etching an inorganic film for transference after forming a fine pattern preferably has in-plane uniformity in the order of nanometer, the metal atoms are preferably of one element.

When the metal compound contains metal-oxygen atom bonds, a metal-containing film formed from the composition for forming a metal-containing film has excellent etching selectivity. Regarding the oxygen atom, one may be bonded to one metal atom, or multiple oxygen atoms may be bonded, but preferably, a structure in which two oxygen atoms are bonded to a metal atom is mainly contained. When a structure in which two oxygen atoms are bonded (covalent bond or coordinate bond) to a metal atom is mainly contained, the metal compound can have a more linear structure as in -M-O-M-O- (M being a particular metal atom), and solvent solubility can be enhanced.

As the metal compound (A) of the present invention, a commercially available metal compound may be used, and for example, it is possible to use a metal-containing compound having a hydrolysable group (hereinafter, hydrolysable metal-containing compound (a)). The metal compound (A) can also be synthesized by a method of performing a hydrolysis condensation reaction of the hydrolysable metal-containing compound (a) etc. That is, the metal compound (A) can be a compound derived from the hydrolysable metal-containing compound (a). Here, a "hydrolysis condensation reaction" refers to a reaction in which a hydrolysable group contained in the hydrolysable metal-containing compound (a) is hydrolyzed and converted to -OH, and two -OH groups obtained undergo dehydration condensation to form -O-.

As the metal compound (A) of the present invention, it is preferable to use the hydrolysable metal-containing compound (a), a hydrolysis condensation reaction product of the hydrolysable metal-containing compound (a), or a compound which is a product of a reaction between these compounds and a material that may become a monodentate ligand or a polydentate ligand, more preferably a hydrolysis condensation reaction product of the hydrolysable metal-containing compound (a), or a compound which is a product of a reaction between a hydrolysis condensation reaction product of the hydrolysable metal-containing compound (a) and a material that may become a monodentate ligand or a polydentate ligand.

Such a metal compound (A) reacts favorably with the crosslinking agent (B) at the time of baking, and a metal-containing film excellent in filling property can be formed. Furthermore, from the viewpoint of dry etching resistance, it is more preferable to use a hydrolysis condensation reaction product of the hydrolysable metal-containing compound (a), or a compound which is a product of a reaction between a hydrolysis condensation reaction product of the hydrolysable metal-containing compound (a) and a material that may become a monodentate ligand or a polydentate ligand.

### [(a) Hydrolysable Metal-Containing Compound]

The above-described hydrolysable metal-containing compound (a) is a metal compound (I) having a hydrolysable group, a hydrolysis product of the metal compound (I), a hydrolysis condensation product of the metal compound (I), or a combination of the above. One kind of the metal compound (I) can be used, or two or more kinds thereof can be used in combination.

Examples of the metal compound (I) include a compound (I-1), represented by the following formula (2), etc. When such a metal compound (I-1) is contained, a stable compound (A) can be formed, and dry etching resistance can be enhanced.

LnₐMXn_{b} (2)

In the formula, M represents any of Ti, Zr, and Hf; Ln independently represents a monodentate ligand having 1 to 30 carbon atoms or a polydentate ligand having 1 to 30 carbon atoms; Xn independently represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.

### (Hydrolysable Group)

The hydrolysable group Xn of the general formula (2) may be, for example, one or more kinds selected from halogen atoms, alkoxy groups, carboxylate groups, acyloxy groups, and -NR^{a}R^{b}. R^{a} and R^{b} each independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR^{a}R^{b} include an unsubstituted amino group, a methylamino group, a dimethylamino group, a diethylamino group, a dipropylamino group, etc.

As the hydrolysable group Xn, an alkoxy group is preferable, and an i-propoxy group, an n-butoxy group, or a t-butoxy group is more preferable.

Examples of the ligand Ln in the general formula (2) include the following monodentate ligands and polydentate ligands.

### (Monodentate Ligand)

Examples of the monodentate ligands include a hydroxo ligand (OH), carboxy ligands, amido ligands, amine ligands, an ammonia ligand (NH₃), olefin ligands, etc.

Examples of the carboxy ligands include a formate ligand (OOCH), an acetate ligand (OOCMe), a propionate ligand (OOCEt), and a butyrate ligand (OOCPr).

Examples of the amido ligands include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligands include pyridine, a trimethylamine ligand, a piperidine ligand, etc.

Examples of the olefin ligands include: linear olefins, such as ethylene and propylene; cyclic olefins, such as cyclopentene, cyclohexene, and norbornene; etc.

### (Polydentate Ligand)

Examples of the polydentate ligands include ligands derived from hydroxy acid esters, ligands derived from β-diketones, ligands derived from β-keto esters, ligands derived from α,α-dicarboxylic acid esters, hydrocarbons having a π bond, diphosphines, etc.

Examples of the hydroxy acid esters include glycolic acid esters, lactic acid esters, 2-hydroxycyclohexane-1-carboxylic acid esters, salicylic acid esters, etc.

Examples of the β-keto esters include acetoacetic acid esters, α-alkyl-substituted acetoacetic acid esters, β-ketopentanoic acid esters, benzoylacetic acid esters, 1,3-acetonedicarboxylic acid esters, etc.

Examples of the β-diketones include acetylacetone, methylacetylacetone, and ethylacetylacetone.

Examples of the α,α-dicarboxylic acid esters include malonic acid diesters, α-alkyl-substituted malonic acid diesters, α-cycloalkyl-substituted malonic acid diesters, α-aryl-substituted malonic acid diesters, etc.

Examples of the hydrocarbons having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphines include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, etc.

In the general formula (2), a + b = 4, and "a" and "b" each represent an integer of 0 to 4. "a" is preferably 0 to 3, more preferably 0 to 2, further preferably 1 or 2, and particularly preferably 2. "b" is preferably 2 to 4, more preferably 2 or 3, and further preferably 2. By setting "a" and "b" to be within the above ranges, the stability of the metal compound can be enhanced.

Examples of the hydrolysable metal-containing compound (a) include: compounds containing titanium, such as diisopropoxybis(2,4-pentanedionate)titanium(IV), tetra-n-butoxytitanium(IV), tetra-n-propoxytitanium(IV), tri-n-butoxymonostearatetitanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV); compounds containing zirconium, such as dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono(2,4-pentanedionate)zirconium(IV), triisopropoxymono(2,4-pentanedionate) zirconium(IV), tri(3-methacryloxypropyl)methoxyzirconium(IV), and tri(3-acryloxypropyl)methoxyzirconium(IV); and compounds containing hafnium, such as diisopropoxybis(2,4-pentanedionate)hafnium(IV), tetrabutoxyhafnium(IV), tetraisopropoxyhafnium(IV), tetraethoxyhafnium(IV), and dichlorobis(cyclopentadienyl)hafnium(IV).

From the viewpoint of the availability of raw materials, the above-described metal compound preferably has a structure represented by the following general formula (3).

M(OR^{1A})₄ (3)

In the formula, M is as defined above, and R^{1A} represents a monovalent organic group having 1 to 20 carbon atoms.

In the general formula (3), R^{1A} represents a monovalent organic group having 1 to 20 carbon atoms, preferably a methyl group, an ethyl group, an n-propyl group, an i-propyl group, an n-butyl group, or a t-butyl group, and more preferably an isopropyl group, an n-butyl group, or a t-butyl group.

As described above, as the metal compound (A), the hydrolysable metal-containing compound (a) itself or a hydrolysis condensation reaction product thereof can be used, and it is also possible to use a product of a reaction with another compound as described below.

At the time of the synthesis reaction of the metal compound (A), a compound that may become a monodentate ligand or a polydentate ligand (hereinafter, compound (b) for forming a ligand) in the metal compound can be contained besides the hydrolysable metal-containing compound (a).

Examples of the compound (b) for forming a ligand include compounds, such as organic compounds derived from a hydroxo ligand, a carboxy ligand, an amido ligand, an amine ligand, an ammonia ligand, an olefin ligand, etc. and organic compounds derived from a ligand derived from a hydroxy acid ester, a ligand derived from a β-diketone, a ligand derived from a β-keto ester, a ligand derived from an α,α-dicarboxylic acid ester, etc., given as examples of the Ln in the general formula (2). Examples also include compounds having multiple hydroxy groups etc.

The metal compound (A) can be obtained by allowing a reaction between: a compound derived from the metal compound represented by the formula (2); and an organic compound having 1 to 30 carbon atoms and containing at least one crosslinking group represented by any of the general formulae (a-1) to (a-4), (b-1) to (b-4), (c-1) to (c-3), (d-1), and (d-2) described below. In this manner, a crosslinking group can be introduced to the component (A).

Furthermore, the compound (b) for forming a ligand may be an organic compound having 1 to 30 carbon atoms and containing at least one crosslinking group represented by any of the following general formulae (a-1) to (a-4), (b-1) to (b-4), (c-1) to (c-3), (d-1), and (d-2) .

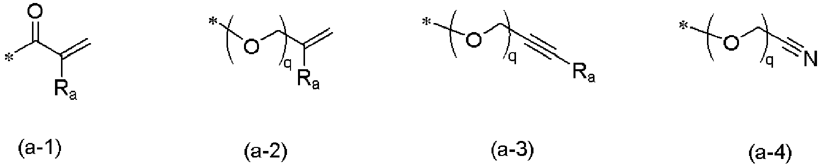

In the general formulae (a-1) to (a-4), Rₐ independently represents a hydrogen atom or a monovalent organic group having 1 to 10 carbon atoms, "q" represents 0 or 1, and "*" represents an attachment point.

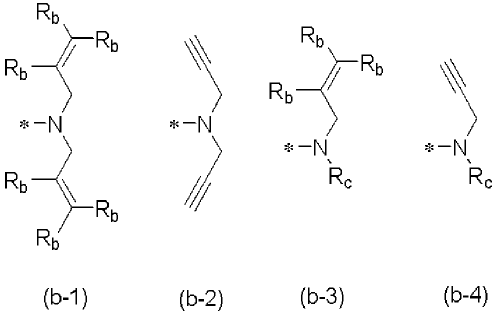

In the general formulae, R_{b}s each independently represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point.

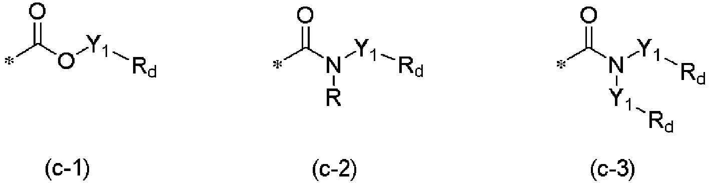

In the general formulae (c-1) to (c-3), Y₁ independently represents a divalent organic group having 1 to 20 carbon atoms, R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms, R_{d} independently represents an organic group whose protecting group is to be removed by an action of an acid, heat, or both to generate one or more hydroxy groups or carboxyl groups, R_{d} being represented by one of the following general formulae (c-4), and "*" represents an attachment point.

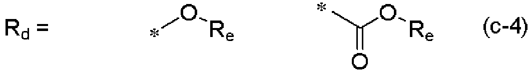

In the general formulae (c-4), Rₑ represents an organic group whose protecting group is to be removed by an action of an acid, heat, or both, and "*" represents an attachment point to Y₁.

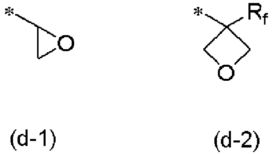

In the formulae, R_{f} represents a hydrogen atom or an organic group having 1 to 10 carbon atoms, and "*" represents an attachment point.

When the compound for forming a metal-containing film contains at least one crosslinking group represented by any of the general formulae (a-1) to (a-4), (b-1) to (b-4), (c-1) to (c-3), (d-1), and (d-2), the thermosetting property of the metal compound can be enhanced. The heat resistance of the metal compound can be enhanced by organic crosslinking between ligands, and therefore, the reaction with the crosslinking agent at the time of baking can be further promoted.

From the viewpoints of the productivity and stability of the compound for forming a metal-containing film, the compound (b) for forming a ligand is more preferably a compound derived from a carboxy ligand, a compound derived from a ligand derived from a β-diketone, or a compound having a compound having a plurality of hydroxy groups. One kind of these compounds may be used, or two or more kinds thereof may be used in combination.

Examples of the compound derived from a carboxy ligand include compounds represented by the following general formula (4).

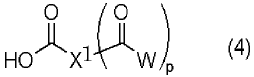

In the formula, "p" represents 0 or 1. When "p" is 1, X¹ represents a divalent organic group having 2 to 20 carbon atoms, and W represents an alkoxy group having 1 to 10 carbon atoms, the following general formula (4-A), or any of the crosslinking groups represented by the general formulae (b-1) to (b-4). When "p" is 0, X¹ represents a monovalent organic group having 8 to 30 carbon atoms including an aromatic ring and a crosslinking group of either of the structures represented by the general formulae (a-2) and (a-3).

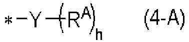

In the general formula (4-A), Y represents a saturated divalent organic group having 1 to 20 carbon atoms or an unsaturated divalent organic group having 2 to 20 carbon atoms; R^{A} represents any of the structures represented by the general formulae (a-1) to (a-4); "h" represents 1 to 6; and "*" represents an attachment point to the carbon atom of the carbonyl group.

A compound for forming a metal-containing film containing a carboxy ligand having such a structure can improve heat resistance at the time of baking, and therefore, the reaction with the crosslinking agent (B) is easily promoted, and it is possible to form a metal-containing film having better filling property.

In the general formula (4), it is preferable that "p" is 1 and W has a structure represented by one of the following general formulae (4-B).

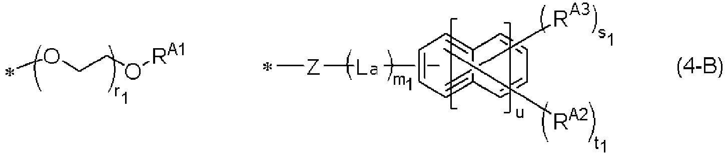

In the general formulae (4-B), R^{A1} represents a structure represented by the general formula (a-1); R^{A2} represents either of the structures represented by the general formulae (a-2) and (a-3); Z represents an oxygen atom or a secondary amine; La represents a divalent hydrocarbon group having 1 to 10 carbon atoms; R^{A3} represents a saturated divalent organic group having 1 to 20 carbon atoms or an unsaturated divalent organic group having 2 to 20 carbon atoms; "t₁" represents 1 to 6 and "s₁" represents 0 to 5, provided that t₁+s₁ is 1 or more and 6 or less; "r₁" represents 1 to 10; "u" represents 0 or 1; "m₁" represents 0 or 1; and "*" represents an attachment point to the carbon atom of the carbonyl group.

A compound for forming a metal-containing film containing a carboxy ligand having such a structure can improve heat resistance at the time of baking, and therefore, the reaction with the crosslinking agent (B) is easily promoted, and it is possible to form a metal-containing film having better filling property.

In the general formula (4), it is preferable that "p" represents 1, W represents an alkoxy group having 1 to 10 carbon atoms, and X¹ represents any of the structures represented by the following general formulae (4-C) .

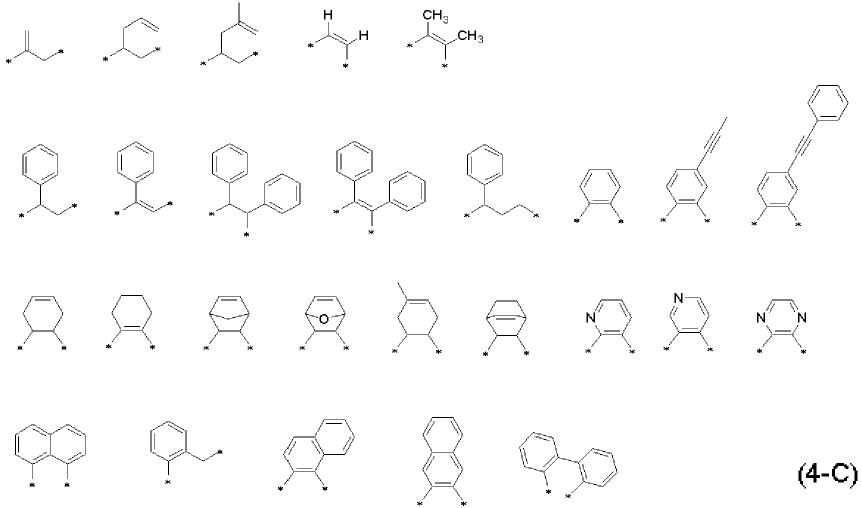

In the formulae, "*" represents an attachment point to a carbon atom of a carbonyl group.

A compound for forming a metal-containing film containing a carboxy ligand having such a structure can improve heat resistance at the time of baking, and therefore, the reaction with the crosslinking agent (B) is easily promoted, and it is possible to form a metal-containing film having better filling property.

Alternatively, in the general formula (4), it is also preferable that "p" is 0, and X¹ is one of the structures represented by the following formulae (4-D).

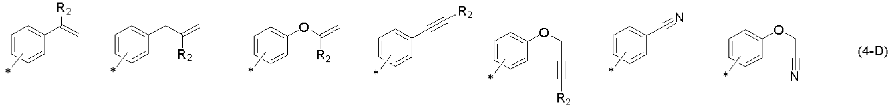

In the formulae, R₂ represents a hydrogen atom or a monovalent organic group having 1 to 10 carbon atoms; and "*" represents an attachment point to the carbon atom of the carbonyl group. Here, the R₂ applies only in the above formulae.

Other examples of the compound derived from a carboxy ligand include compounds represented by the following general formula (5).

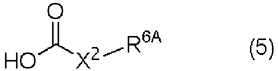

In the formula, X² represents a divalent organic group having 1 to 31 carbon atoms; and R^{6A} represents any of the general formulae (c-1) to (c-3).

In the general formula (5), X² represents a divalent organic group having 1 to 31 carbon atoms, and in view of thermosetting property, preferably represents a saturated hydrocarbon group having 1 to 20 carbon atoms or an unsaturated hydrocarbon group having 2 to 20 carbon atoms.

In the general formulae (c-1) to (c-3), Y₁ independently represents a divalent organic group having 1 to 20 carbon atoms, and may be a substituted or unsubstituted saturated divalent organic group having 1 to 20 carbon atoms or a substituted or unsubstituted unsaturated divalent organic group having 2 to 20 carbon atoms. Y₁ is, for example, a substituted or unsubstituted aryl group having 6 to 20 carbon atoms or a substituted or unsubstituted arylalkyl group having 7 to 20 carbon atoms, and Y₁ is preferably a saturated hydrocarbon group having 1 to 20 carbon atoms or an unsaturated hydrocarbon group having 2 to 20 carbon atoms.

When the Y₁ in the general formulae (c-1) to (c-3) represents a saturated hydrocarbon group having 1 to 20 carbon atoms or an unsaturated hydrocarbon group having 2 to 20 carbon atoms, thermosetting property can be further improved when a composition for forming a metal-containing film is formed with the compound for forming a metal-containing film. This is also desirable from the viewpoint of the availability of raw materials.

Specific examples of Y₁ include the following structures, but are not limited thereto. 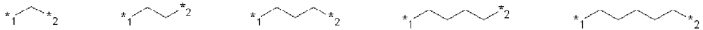 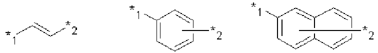 "*1" represents an attachment point to the oxygen atom or the nitrogen atom; and "*2" represents an attachment point to R_{d}.

The Rₑ in the general formula (c-4) represents an organic group whose heat/acid-labile group is to be removed by an action of an acid, heat, or both, preferably represents a tertiary hydrocarbyl group, or a group that forms an acetal structure together with an adjacent oxygen atom, and particularly preferably represents a tertiary hydrocarbyl group. As the tertiary hydrocarbyl group, those having 4 to 20 carbon atoms are preferable, and in particular, those having fewer carbon atoms are more preferable.

A compound for forming a metal-containing film containing a carboxy ligand having such a structure can improve heat resistance at the time of baking, and therefore, the reaction with the crosslinking agent (B) is easily promoted, and it is possible to form a metal-containing film having better filling property.

Examples of the compound derived from a ligand derived from a β-diketone include compounds represented by the following general formula (6).

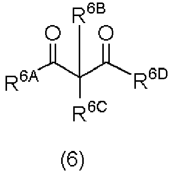

In the formula, R^{6A} to R^{6D} each represent a hydrogen atom or a monovalent organic group having 1 to 20 carbon atoms optionally including a crosslinking group represented by any of the general formulae (a-1) to (a-4), (b-1) to (b-4), (d-1), and (d-2).

The compounds of the general formula (6) preferably contain at least one crosslinking group represented by any of the general formulae (a-1) to (a-4), (b-1) to (b-4), and (d-1) to (d-2). Such a compound is capable of improving the heat resistance at the time of baking, and therefore, the reaction with the crosslinking agent (B) is facilitated, so that it is possible to form a metal-containing film having better filling property. Therefore, such a compound is preferable.

In the formula (6), R^{6A} and R^{6D} each represent a hydrogen atom or a monovalent organic group having 1 to 20 carbon atoms and optionally containing a crosslinking group represented by any of the general formulae (a-1) to (a-4), (b-1) to (b-4), (d-1), and (d-2); preferably a hydrogen atom, a substituted or unsubstituted alkyl group having 1 to 10 carbon atoms, a substituted or unsubstituted aryl group having 6 to 20 carbon atoms, a substituted or unsubstituted allyl-containing group having 2 to 10 carbon atoms, a substituted or unsubstituted ethynyl-containing group having 2 to 10 carbon atoms, or a monovalent organic group having 1 to 20 carbon atoms and optionally containing a crosslinking group represented by any of the general formulae (a-1) to (a-4), (b-1) to (b-4), (d-1), and (d-2); and more preferably a methyl group, an ethyl group, a phenyl group, an allyloxy group, a propargyloxy group, an alkoxy group having 1 to 10 carbon atoms, or a monovalent organic group having 1 to 20 carbon atoms and optionally containing a crosslinking group represented by any of the general formulae (a-1) to (a-4), (b-1) to (b-4), (d-1), and (d-2).

When R^{6A} and R^{6D} do not contain a crosslinking group represented by any of the general formulae (a-1) to (a-4), (b-1) to (b-4), (d-1), and (d-2), a methyl group, a methoxy group, or an ethoxy group is preferable.

R^{6B} and R^{6C} each represent a hydrogen atom or a monovalent organic group having 1 to 20 carbon atoms and optionally containing a crosslinking group represented by any of the general formulae (a-1) to (a-4), (b-1) to (b-4), (d-1), and (d-2); preferably a hydrogen atom, a substituted or unsubstituted alkyl group having 1 to 10 carbon atoms, a substituted or unsubstituted aryl group having 6 to 20 carbon atoms, a substituted or unsubstituted allyl-containing group having 2 to 10 carbon atoms, a substituted or unsubstituted ethynyl-containing group having 2 to 10 carbon atoms, or a monovalent organic group having 1 to 20 carbon atoms and containing a crosslinking group represented by any of the general formulae (a-1) to (a-4), (b-1) to (b-4), (d-1), and (d-2); and more preferably a hydrogen atom, a methyl group, an ethyl group, a phenyl group, an allyloxy group, a propargyloxy group, or a monovalent organic group having 1 to 20 carbon atoms and containing a crosslinking group represented by any of the general formulae (a-1) to (a-4), (b-1) to (b-4), (d-1), and (d-2). R^{6B} and R^{6C} may also be bonded with each other to form a cyclic ether structure.

When R^{6B} has a substituent other than a hydrogen atom, R^{6C} is preferably a hydrogen atom. It is preferable that at least one of R^{6B} and R^{6C} is a hydrogen atom. When R^{6B} and R^{6C} do not contain a crosslinking group represented by any of the general formulae (a-1) to (a-4), (b-1) to (b-4), (d-1), and (d-2), it is preferable that both R^{6B} and R^{6C} represent a hydrogen atom.

Examples of the compound having multiple hydroxy groups include dihydric alcohols represented by any of the following general formulae (7-A) to (7-C) etc.

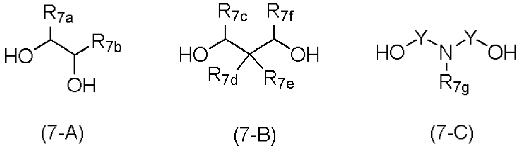

In the formulae, R₇ₐ and R_{7b} each represent a hydrogen atom or a monovalent organic group having 1 to 20 carbon atoms optionally including a crosslinking group represented by any of the general formulae (a-1) to (a-4), (d-1), and (d-2); R_{7c} to R_{7g} each represent a hydrogen atom or a monovalent organic group having 1 to 20 carbon atoms optionally including a crosslinking group represented by any of the general formulae (a-1) to (a-4), (b-1) to (b-4), (d-1), and (d-2); and Y represents a divalent organic group having 1 to 10 carbon atoms. In the general formula (7-A), the adjacent R₇ₐ and R_{7b} may be bonded to each other to form an unsaturated or saturated cyclic structure.

The compounds of the general formulae (7-A) to (7-C) preferably contain at least one crosslinking group represented by any of the general formulae (a-1) to (a-4), (b-1) to (b-4), (d-1), and (d-2). Such a compound improves heat resistance at the time of baking, so that reaction with the crosslinking agent (B) is easily promoted, and it is possible to form a metal-containing film having better filling property. Therefore, such a compound is preferable.

In the formula (7-A), R₇ₐ and R_{7b} each represent a hydrogen atom or a monovalent organic group having 1 to 20 carbon atoms and optionally containing a crosslinking group represented by any of the general formulae (a-1) to (a-4), (d-1), and (d-2); preferably a hydrogen atom, a substituted or unsubstituted alkyl group having 1 to 10 carbon atoms, a substituted or unsubstituted aryl group having 6 to 20 carbon atoms, a substituted or unsubstituted allyl-containing group having 2 to 10 carbon atoms, a substituted or unsubstituted ethynyl-containing group having 2 to 10 carbon atoms, or a monovalent organic group having 1 to 20 carbon atoms and containing a crosslinking group represented by any of the general formulae (a-1) to (a-4), (d-1), and (d-2). When a crosslinking group represented by any of the general formulae (a-1) to (a-4), (d-1), and (d-2) is not contained, R₇ₐ and R_{7b} are each a hydrogen atom.

In the formula (7-B), R_{7c} and R_{7f} each represent a hydrogen atom or a monovalent organic group having 1 to 20 carbon atoms and optionally containing a crosslinking group represented by any of the general formulae (a-1) to (a-4), (b-1) to (b-4), (d-1), and (d-2); preferably a hydrogen atom or a substituted or unsubstituted alkyl group having 1 to 10 carbon atoms; and more preferably a hydrogen atom.

In the formula (7-B), R_{7d} represents a hydrogen atom or a monovalent organic group having 1 to 20 carbon atoms and containing a crosslinking group represented by any of the general formulae (a-1) to (a-4), (b-1) to (b-4), (d-1), and (d-2); preferably a monovalent organic group having 1 to 20 carbon atoms and containing a crosslinking group represented by any of the general formulae (a-1) to (a-4), (b-1) to (b-4), (d-1), and (d-2). R₇ₑ represents a hydrogen atom or a monovalent organic group having 1 to 20 carbon atoms and optionally containing a crosslinking group represented by any of the general formulae (a-1) to (a-4), (b-1) to (b-4), (d-1), and (d-2); preferably a hydrogen atom, an alkyl group having 1 to 10 carbon atoms, or an aryl group; and further preferably a hydrogen atom. R_{7d} and R₇ₑ may also be bonded with each other to form a cyclic ether structure.

In the formula (7-C), R_{7g} preferably represents a monovalent organic group having 1 to 20 carbon atoms and containing a crosslinking group represented by any of the general formulae (a-1) to (a-4), (b-1) to (b-4), (d-1), and (d-2). Y represents a divalent organic group having 1 to 10 carbon atoms, preferably a divalent hydrocarbon group having 1 to 10 carbon atoms, more preferably a hydrocarbon group having 1 to 5 carbon atoms from the viewpoint of the availability of raw materials, further preferably a methylene group or an ethylene group, and particularly preferably an ethylene group.

A compound for forming a metal-containing film containing a polydentate ligand having such a structure has improved heat resistance at the time of baking, and therefore, the reaction with the crosslinking agent (B) is easily promoted, so that it is possible to form a metal-containing film having better filling property.

When the compound for forming a metal-containing film has a ligand derived from a compound (b) for forming a ligand containing any of the groups represented by the formulae (a-1) to (a-4), (b-1) to (b-4), (c-1) to (c-3), (d-1), and (d-2), the ligand containing any of the groups represented by the formulae (a-1) to (a-4), (b-1) to (b-4), (c-1) to (c-3), (d-1), and (d-2) is preferably contained in an amount of 10 mol% to 90 mol%, more preferably 20 mol% to 80 mol%, and further preferably 25 mol% to 75 mol% of the total amount of ligands coordinated to the metal atoms. A ligand derived from a compound (b) for forming a ligand that does not contain a group represented by any of the formulae (a-1) to (a-4), (b-1) to (b-4), (c-1) to (c-3), (d-1), and (d-2) is preferably contained in an amount of 0 mol% to 50 mol%, more preferably 0 mol% to 30 mol% of the total amount of ligands coordinated to the metal atoms. A ligand other than a ligand of the compound (b) for forming a ligand, for example, a ligand derived from an alkoxy group having 1 to 10 carbon atoms is preferably contained in an amount of 0 mol% to 90 mol%, more preferably 20 mol% to 80 mol% of the total amount of ligands coordinated to the metal atoms.

Furthermore, on the occasion of the synthesis reaction of the metal compound (A), a silicon-containing compound (c) may be added besides the compound (b) for forming a ligand.

By substituting a hydrolysable group of the hydrolysable metal-containing compound (a) with the silicon-containing compound, it is possible to enhance the stability of the metal compound (A) in the composition for forming a metal-containing film.

Examples of the silicon-containing compound include compounds having a structure represented by the following formula (8).

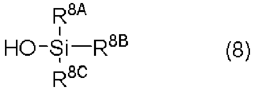

In the (8), R^{8A}, R^{8B}, and R^{8C} each represent any organic group selected from: an organic group having 1 to 30 carbon atoms including a crosslinking group of any of the structures represented by the following general formulae (e-1) to (e-3); a substituted or unsubstituted alkyl group having 1 to 20 carbon atoms; and an aryl group having 6 to 20 carbon atoms.

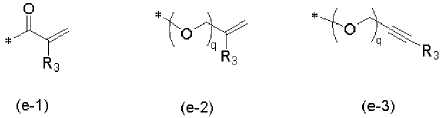

In the general formulae (e-1) to (e-3), R₃ represents a hydrogen atom or a monovalent organic group having 1 to 10 carbon atoms; "q" represents 0 or 1; and "*" represents an attachment point.

The silicon-containing compound is preferably any one represented by the following formulae, and from the viewpoint of productivity, trimethylsilanol is more preferable.

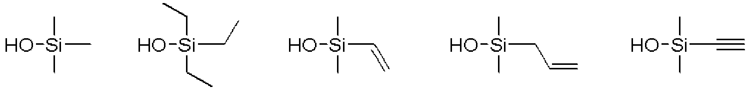

When the metal compound (A) contains the compound (b) for forming a ligand and the ligand derived from the silicon-containing compound (c), the amount of the compound (b) for forming a ligand contained in the metal compound (A) is preferably 10 mol% to 100 mol%, more preferably 20 mol% to 80 mol%, and further preferably 25 mol% to 75 mol% of the total amount of ligands coordinated to the metal atoms. The ligand derived from the silicon-containing compound (c) is preferably contained in an amount of 10 mol% to 90 mol%, more preferably 20 mol% to 80 mol%, and further preferably 25 mol% to 75 mol% of the total amount of ligands coordinated to the metal atoms. Ligands other than the ligands of the compound (b) for forming a ligand and the silicon-containing compound (c), for example, a ligand derived from an alkoxy group having 1 to 10 carbon atoms, are preferably contained in an amount of 0 mol% to 90 mol%, more preferably 0 mol% to 75 mol% of the total amount of ligands coordinated to the metal atoms.

The method for synthesizing the metal compound (A) is not particularly limited. For example, a metal alkoxide or a metal acetylacetonate (acac) can be used as the hydrolysable metal-containing compound (a), and the metal compound (A) can be obtained by allowing the alkoxy or acac metal to react with the ligand derived from the compound (b) for forming a ligand. The hydrolysable metal-containing compound (a) may be subjected to hydrolysis condensation and then the product may be allowed to react with the ligand derived from the compound (b) for forming a ligand, or the hydrolysable metal-containing compound (a) may be allowed to react with the ligand derived from the compound (b) for forming a ligand and then the product may be subjected to hydrolysis condensation. If it is difficult to control the hydrolysis condensation, the reaction with the ligand derived from the compound (b) for forming a ligand may be performed in a non-hydrous environment. The methods are preferably adjusted appropriately in accordance with the properties required in the metal compound (A) and the metal-containing film. When the silicon-containing compound (c) and the ligand derived from the compound (b) for forming a ligand are to be contained as ligands, it is preferable to allow the hydrolysable metal-containing compound (a) and the silicon-containing compound (c) to react and then allow the product to react with the ligand derived from the compound (b) for forming a ligand.

As a method for performing a hydrolysis condensation reaction using the hydrolysable metal-containing compound (a), examples include a method of subjecting the hydrolysable metal-containing compound (a) to a hydrolysis condensation reaction in a solvent containing water. In this case, another compound having a hydrolysable group may be added as necessary. In addition, as a catalyst for the hydrolysis condensation reaction, an acid, such as acetic acid, may be added. The lower limit of the amount of water used in this hydrolysis condensation reaction is preferably 0.2-fold, more preferably 1-fold, and further preferably 3-fold, relative to the hydrolysable groups contained in the hydrolysable metal-containing compound (a) etc., on the molar basis. The upper limit of the amount of the water is preferably 20-fold, more preferably 15-fold, and further preferably 10-fold on the molar basis.

The solvent used in the synthesis reaction of the metal compound (A) is not particularly limited, and for example, a solvent given as an example of the solvent (C) described later can be used. Typical solvents and solvent mixtures contain an ester, ether, or alcohol functional group, and examples thereof include a mixture of propylene glycol monomethyl ether acetate (PGMEA) and propylene glycol monomethyl ether (PGME) at 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### <(B) Crosslinking Agent>

The crosslinking agent (B) contained in the inventive composition for forming a metal-containing film contains, per molecule, 2 or more and 4 or fewer cyclic ether structures having 2 to 13 carbon atoms. The crosslinking agent may contain 3 of the cyclic ether structures per molecule. If fewer than 2 or more than 4 of the cyclic ether structures are contained per molecule, the stability of the metal compound in the composition is degraded, and it is not possible to form a metal-containing film having excellent filling property.

Such a crosslinking agent does not degrade the stability of the metal compound in the composition for forming a metal-containing film, and reacts with the metal compound during baking, making it possible to suppress volume shrinkage of the metal compound and making it possible to form a metal-containing film excellent in filling property.

The cyclic ether structures having 2 to 13 carbon atoms are preferably epoxy groups or oxetanyl groups.

Such cyclic ether structures are excellent from the viewpoints of reactivity with the metal compound and productivity, and are therefore preferable.

The crosslinking agent may include 2 or more epoxy groups or oxetanyl groups per molecule, and may be a compound or a polymer, such as an oligomer or a polymer. If the amount of the carbon component in the metal-containing film is large, there is a risk of dry etching resistance being degraded, and therefore, a monomolecular compound is preferable to a polymer. The polymer may have a weight-average molecular weight Mw of 1,000 to 10,000, and the weight-average molecular weight Mw and the number-average molecular weight Mn can be determined by gel permeation chromatography (GPC) in terms of standard polystyrene, using tetrahydrofuran as an eluent.

The crosslinking agent (B) is preferably one of the organic compounds represented by the following formulae (1) .

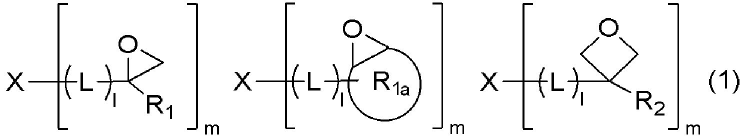

In the formulae (1), X represents an m-valent organic group having 1 to 50 carbon atoms; L represents a carbonyl group or a divalent organic group having 1 to 10 carbon atoms; R₁ and R₂ each independently represent a hydrogen atom, a hydroxy group, an alkyl group having 1 to 10 carbon atoms, an aryl group having 6 to 10 carbon atoms, or an alkoxy group having 1 to 10 carbon atoms; R₁ₐ represents an alicyclic hydrocarbon group having 3 to 10 carbon atoms; "l" represents 0 or 1; and "m" represents 2 to 4.

In the formulae, R₁ is preferably a hydrogen atom; and R₂ is preferably a hydrogen atom, a methyl group, or an ethyl group, further preferably an ethyl group.

In the formula, R₁ₐ represents an alicyclic hydrocarbon group having 3 to 10 carbon atoms, preferably a cycloalkyl group having 5 to 10 carbon atoms, more preferably a cyclopentyl group or a cyclohexyl group.

In the formulae, L represents a carbonyl group or a divalent organic group having 1 to 10 carbon atoms, preferably an alkylene group having 1 to 10 carbon atoms, further preferably a carbonyl group or a methylene group. "l" represents 0 or 1, preferably 1.

In the formulae, X represents an organic group having a valency of "m" and having 1 to 50 carbon atoms, and preferably contains one or more of a quaternary carbon atom, an aromatic ring, an alicyclic hydrocarbon, or a heterocycle.

Such a crosslinking agent has excellent heat resistance, and therefore, is capable of reacting favorably with the metal compound at the time of baking, and makes it possible to form a metal-containing film having excellent filling property.

Examples of favorable structures of X include the following.

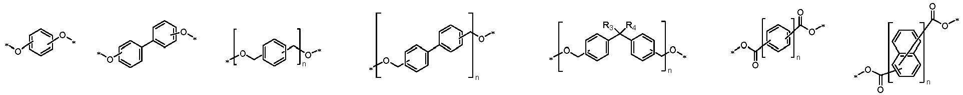

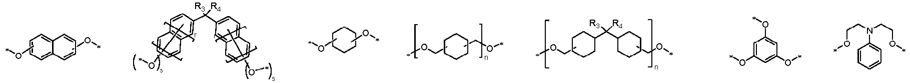

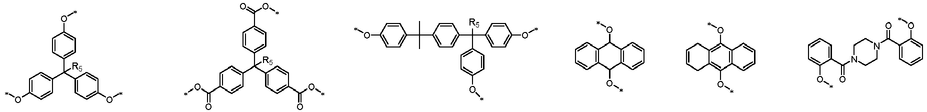

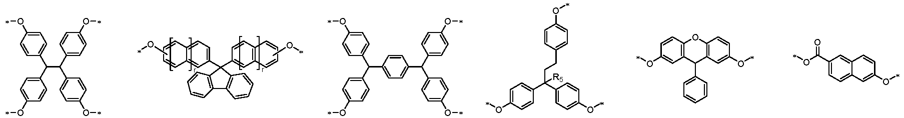

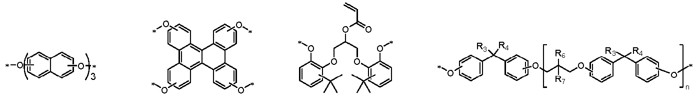

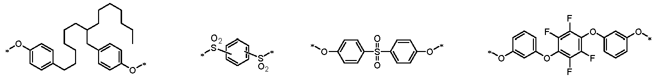

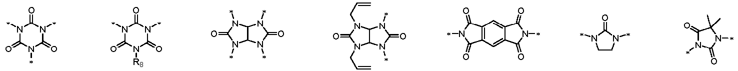

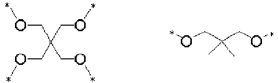

In the formulae, "n" represents 1 to 5; "r" represents 0 or 1; "s" represents 1 or 2; R₃ and R₄ each independently represent a hydrogen atom or an alkyl group having 1 to 10 carbon atoms and optionally containing a halogen atom; R₅ represents a hydrogen atom, a hydroxy group, or an alkyl group having 1 to 10 carbon atoms; R₆ and R₇ each independently represent a hydrogen atom, a hydroxy group, or an organic group containing a group having 1 to 10 carbon atoms selected from alkyl, alkylene, and alkynyl; R₈ represents a hydrogen atom, a hydroxy group, or an organic group containing a group having 1 to 10 carbon atoms selected from alkyl, alkylene, and alkynyl; "*" represents an attachment point to the L; and a carbon atom in an aromatic ring in the formulae optionally has a substituent selected from a hydroxy group, a carboxy group, an ethenyl group, an ethynyl group, an amino group, a sulfide group, and an alkyl group having 1 to 10 carbon atoms optionally including the groups.

The R₃ and R₄ each represent a hydrogen atom or an alkyl group having 1 to 10 carbon atoms and optionally containing a halogen atom, and are more preferably a hydrogen atom, a methyl group, or a CF₃ group.

The R₅ represents a hydrogen atom, a hydroxy group, or an alkyl group having 1 to 10 carbon atoms, and are more preferably a hydrogen atom or a methyl group.

The R₆ and R₇ each represent a hydrogen atom, a hydroxy group, or an organic group containing a group having 1 to 10 carbon atoms selected from alkyl, alkylene, and alkynyl, preferably a hydrogen atom, a methyl group, or a hydroxy group.

The R₈ represents a hydrogen atom, a hydroxy group, or an organic group containing a group having 1 to 10 carbon atoms selected from alkyl, alkylene, and alkynyl, preferably a hydrogen atom, a methyl group, or an allyl group.

The "n" represents 1 to 5, preferably 1 to 3, and from the viewpoint of dry etching resistance, further preferably 1.

The "r" represents 0 or 1, and from the viewpoint of dry etching resistance, preferably 0.

A crosslinking agent in which the X has a structure described above has excellent heat resistance, and therefore, can react favorably with the metal compound at the time of baking, and is therefore preferable.

The amount of the crosslinking agent (B) to be contained is preferably 5 to 100 parts by mass, more preferably 10 to 80 parts by mass, and further preferably 15 to 60 parts by mass based on 100 parts by mass of the metal compound (A).

When the amount of the crosslinking agent (B) added is 5 parts by mass or more, it is possible to suppress volume shrinkage of the metal compound and form a metal-containing film excellent in filling property. When the contained amount is 100 parts by mass or less, the amount of outgas during baking can be suppressed, and a metal-containing film having few defects can be formed.

### <(C) Solvent>

The solvent (C) usable in the inventive composition for forming a metal-containing film is not particularly limited as long as the solvent can dissolve the above-described metal compound (A) and crosslinking agent (B), and when contained, a surfactant (D), other additives, etc., described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

### (High-Boiling-Point Solvent)

In the inventive composition for forming a metal-containing film, the solvent (C) may be a mixture of one or more kinds of organic solvent having a boiling point (the value at 1 atmosphere (1013 hPa)) of lower than 180°C and one or more kinds of organic solvent having a boiling point of 180°C or higher (a high-boiling-point solvent).

The high-boiling-point solvent is not particularly limited to hydrocarbons, alcohols, ketones, esters, ethers, or chlorine-based solvents, as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent may be selected suitably from the solvents above, for example, depending on the temperature at which the inventive composition for forming a metal-containing film is heat-treated, etc. The boiling point of the high-boiling-point solvent is preferably 180°C to 300°C, further preferably 200°C to 300°C. When the boiling point is as described, there is no risk of excessive evaporation rate at the baking (heating), and therefore, it is possible to suppress the generation of defects induced by dryness at the time of film formation. Moreover, a solvent having such a boiling point does not remain in the film without evaporating even after the baking. Therefore, there is no risk of the solvent adversely affecting the physical properties, such as etching resistance, of the film.

The solvent (C) is preferably contained in an amount of 200 to 10,000 parts by mass, more preferably 250 to 5,000 parts by mass based on 100 parts by mass of the metal compound (A).

When the high-boiling-point solvent is contained, the contained amount is preferably 1 to 30 parts by mass per 100 parts by mass of the organic solvent having a boiling point lower than 180°C. When the contained amount is as described, sufficient thermal flowability can be imparted at the time of baking and the solvent does not remain in the film and cause degradation in the physical properties, such as etching resistance, of the film. Therefore, such an amount is preferable.

### <Other Components>

When the above-described composition for forming a metal-containing film is usable for a resist underlayer film used in a multilayer resist method, the composition contains one or more of each of the metal compound (A), the crosslinking agent (B), and the solvent (C), and as necessary, the composition may contain one or more of (D) a surfactant, (E) a thermal acid generator, (F) a photo-acid generator, and (G) other crosslinking agents.

In the following, components that may be contained in the inventive composition for forming a metal-containing film besides the above-described metal compound (A), crosslinking agent (B), and solvent (C) will be described.

### [(D) Surfactant]

A surfactant (D) may be contained in the inventive composition for forming a metal-containing film in order to improve coating property in spin-coating. One surfactant can be used, or two or more surfactants can be used in combination. Examples of the surfactant include those disclosed in paragraphs [0142] to [0147] of JP2009-269953A. When the surfactant is contained, the contained amount is preferably 0.001 to 20 parts by mass, more preferably 0.01 to 10 parts by mass per 100 parts by mass of the metal compound (A). When the amount is in such a range, coating property is certainly improved, and a thin, uniform, adhesive film can be formed.

### [(E) Thermal Acid Generator]

In the inventive composition for forming a metal-containing film, a thermal acid generator (E) can be contained to promote a crosslinking reaction by heat.

Examples of a thermal acid generator (E) usable in the inventive composition for forming a metal-containing film include the following general formula (7) etc. 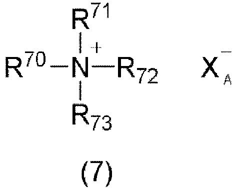 In the formula, X_{A}⁻ represents a non-nucleophilic counter ion. R⁷⁰, R⁷¹, R⁷², and R⁷³ each represent a hydrogen atom, a linear, branched, or cyclic alkyl group, alkenyl group, oxoalkyl group, or oxoalkenyl group, having 1 to 12 carbon atoms, an aryl group having 6 to 20 carbon atoms, or an aralkyl group or aryloxoalkyl group having 7 to 12 carbon atoms, part or all of the hydrogen atoms of these groups optionally being substituted with an alkoxy group or the like. In addition, R⁷⁰ and R⁷¹, or R⁷⁰, R⁷¹, and R⁷² optionally form a ring, and in a case where a ring is formed, R⁷⁰ and R⁷¹, or R⁷⁰, R⁷¹, and R⁷² represent an alkylene group having 3 to 10 carbon atoms, or a heteroaromatic ring having the nitrogen atom in the formula in the ring.

The R⁷⁰, R⁷¹, R⁷², and R⁷³ may be identical to or different from each other, and specific examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, etc.

Examples of the alkenyl group include a vinyl group, an allyl group, a propenyl group, a butenyl group, a hexenyl group, a cyclohexenyl group, etc.

Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, etc.

Examples of the oxoalkenyl group include a 2-oxo-4-cyclohexenyl group, a 2-oxo-4-propenyl group, etc.

Examples of the aryl group include a phenyl group; a naphthyl group; alkoxyphenyl groups, such as a p-methoxyphenyl group, an m-methoxyphenyl group, an o-methoxyphenyl group, an ethoxyphenyl group, a p-tert-butoxyphenyl group, and an m-tert-butoxyphenyl group; alkyl phenyl groups, such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups, such as a methylnaphthyl group and an ethylnaphthyl group; alkoxynaphthyl groups, such as a methoxynaphthyl group and an ethoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group; etc.

Examples of the aralkyl group include a benzyl group, a phenylethyl group, a phenethyl group, etc.

Examples of the aryloxoalkyl group include 2-aryl-2-oxoethyl groups such as a 2-phenyl-2-oxoethyl group, a 2-(1-naphthyl)-2-oxoethyl group, a 2-(2-naphthyl)-2-oxoethyl group, etc.

When R⁷⁰ and R⁷¹, or R⁷⁰, R⁷¹, and R⁷² form a heteroaromatic ring having, in the ring, the nitrogen atom in the formula, examples include imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

Examples of the non-nucleophilic counter ion of X_{A}⁻ include halide ions, such as chloride ion and bromide ion; fluoroalkylsulfonates, such as triflate, 1,1,1-trifluoroethanesulfonate, and nonafluorobutanesulfonate; arylsulfonates, such as tosylate, benzenesulfonate, 4-fluorobenzenesulfonate, and 1,2,3,4,5-pentafluorobenzenesulfonate; alkylsulfonates, such as mesylate and butanesulfonate; imidic acids, such as bis(trifluoromethylsulfonyl) imide, bis(perfluoroethylsulfonyl)imide, and bis(perfluorobutylsulfonyl)imide; methide acids, such as tris(trifluoromethylsulfonyl)methide and tris(perfluoroethylsulfonyl)methide; furthermore, sulfonates, represented by the following general formula (8), being fluorinated in the α-position; and sulfonates, represented by the following general formula (9), being fluorinated in the α- and β-positions.

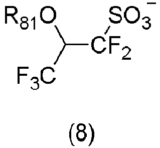

In the general formula (8), R₈₁ represents a hydrogen atom, a linear, branched, or cyclic alkyl group or acyl group having 1 to 23 carbon atoms, an alkenyl group having 2 to 20 carbon atoms, or an aryl group or aryloxy group having 6 to 20 carbon atoms. In the general formula (9), R₉₁ represents a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the thermal acid generator include the following, but are not limited thereto.

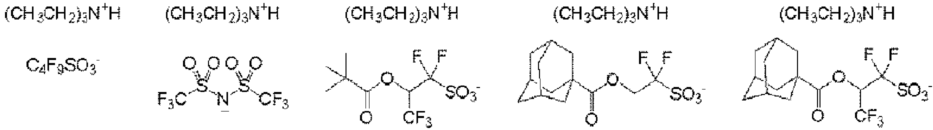

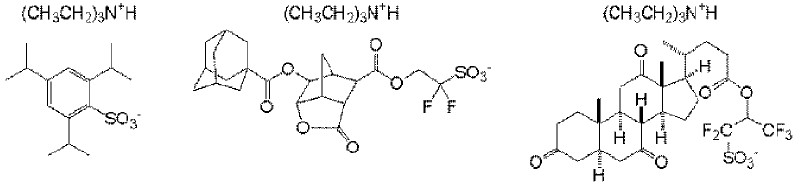

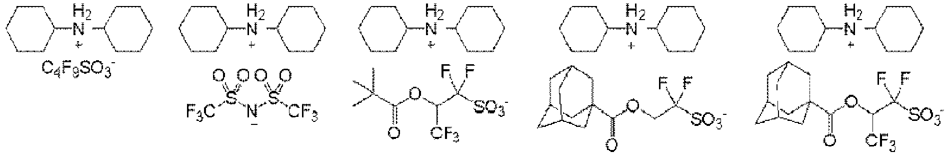

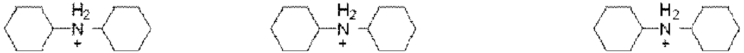

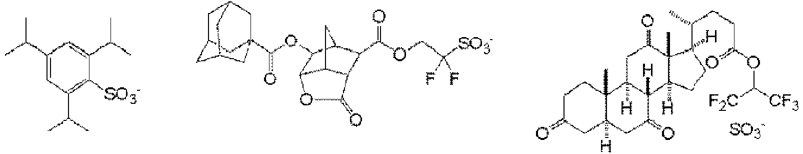

One kind of the thermal acid generator (E), contained in the inventive composition for forming a metal-containing film, may be used, or two or more kinds thereof may be used in combination. The thermal acid generator is preferably contained in an amount of 0.05 to 30 parts by mass, more preferably 0.1 to 10 parts by mass based on 100 parts by mass of the metal compound (A). When the amount is 0.05 parts by mass or more, the amount of generated acid and crosslinking reaction are sufficient, and when 30 parts by mass or less, there is little risk of a mixing phenomenon occurring due to an acid moving to an upper layer resist.

The inventive composition for forming a metal-containing film preferably does not contain a thermal acid generator from the viewpoint of improving the property of filling a stepped substrate. Due to the action of the acid generator, self-condensation of the metal compound is promoted, and therefore, there is a risk of the reaction with the crosslinking agent being inhibited and filling property being degraded.

### [(F) Photo-Acid Generator]

The inventive composition for forming a metal-containing film can contain a photo-acid generator (F) for adjusting appropriately a pattern profile in a resist upper layer film, exposure sensitivity, etc. One kind of the photo-acid generator may be used, or two or more kinds thereof may be used in combination. As the photo-acid generator, for example, those disclosed in paragraphs [0160] to [0179] of JP2009-126940A can be used. The photo-acid generator is preferably contained in an amount of 0.05 to 30 parts by mass, more preferably 0.1 to 10 parts by mass based on 100 parts by mass of the metal compound (A). When the photo-acid generator is contained in the above-described ranges, resolution is excellent, and there is no risk of problems of foreign substances occurring after developing a resist or when removing the resist.

### [(G) Other Crosslinking Agents]

The inventive composition for forming a metal-containing film can also contain another crosslinking agent (G) besides the crosslinking agent (B) to increase curability and further inhibit intermixing with a resist upper layer film. The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and phenol-based crosslinking agents. One kind of the other crosslinking agent (G) can be used, or two or more kinds thereof can be used in combination, and when the crosslinking agent is contained, the contained amount is preferably 5 to 50 parts by mass, more preferably 10 to 40 parts by mass based on 100 parts by mass of the metal compound (A). When the contained amount is 5 parts by mass or more, sufficient curability can be exhibited, and intermixing with a resist upper layer film can be suppressed. Meanwhile, when the contained amount is 50 parts by mass or less, there is no risk of degradation in dry etching resistance due to the proportion of the metal compound (A) in the composition being low.

### [Plasticizer]

The inventive composition for forming a metal-containing film can also contain a plasticizer. The plasticizer is not particularly limited, and various known plasticizers can be widely used. Examples include: low molecular-weight compounds, such as phthalate esters, adipate esters, phosphate esters, trimellitate esters, and citrate esters; and polymers, such as polyether polymers, polyester polymers, and polyacetal polymers described in JP2013-253227A. The amount of the plasticizer to be contained is preferably 1 mass% to 500 mass% based on 100 parts by mass of the metal compound (A). When the contained amount is in such a range, the composition is excellent in filling and planarizing of a pattern.

### <Method for Forming Metal-Containing Film>

In the present invention, by using the above-described composition for forming a metal-containing film, it is possible to form a filling film that serves as a resist underlayer film of a multilayer resist film used in lithography or as a planarizing film for manufacturing a semiconductor.

In the method for forming a resist underlayer film or a filling film by using the inventive composition for forming a metal-containing film, a substrate to be processed is coated with the above-described composition for forming a metal-containing film by a spin-coating method or the like. By using a spin-coating method or the like, an excellent filling property can be achieved. After spin-coating, baking (heating) is performed so as to evaporate the solvent and promote a crosslinking reaction to prevent mixing with a resist upper layer film or a resist middle layer film. The baking is preferably performed at a temperature of 100°C or higher and 600°C or lower for 10 to 600 seconds, more preferably at 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the above-described method for forming a film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film as a resist underlayer film.

By virtue of baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1,000 ppm or less, more preferably 100 ppm or less (volumetric basis). By thus preventing oxidation of the metal-containing film during the baking, the absorption does not increase and the etching resistance does not decrease, which is preferable.

The above-described method makes it possible to form an amorphous metal-containing film, and is therefore preferable. From the viewpoint of dry etching resistance, the metal-containing film is preferably amorphous. When the metal-containing film is amorphous, ions are hardly scattered, and therefore, vertical dry etching is facilitated, and in addition, there is no risk of crystal grains degrading pattern roughness.

### <Patterning Process Using Composition for Forming Metal-Containing Film>

The present invention also provides patterning processes using the above-described composition for forming a metal-containing film. In the following, patterning processes according to multilayer resist processes using the inventive composition for forming a metal-containing film will be described with reference to examples, but the present invention is not limited to the following embodiments. Note that, in the following multilayer resist processes, the resist upper layer film, resist middle layer film, and resist underlayer film are positioned in this order from the side further from the substrate to be processed.

The present invention provides, as a patterning process according to a two-layer resist process using the inventive composition for forming a metal-containing film, a patterning process for forming a pattern in a substrate to be processed, including the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

The present invention also provides, as a patterning process according to a three-layer resist process using the inventive composition for forming a metal-containing film, a patterning process for forming a pattern in a substrate to be processed, including the steps of:
(II-1) forming a resist underlayer film on a substrate to be processed;
(II-2) applying the above-described composition for forming a metal-containing film onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed.

The resist upper layer film in the three-layer resist process described above exhibits etching resistance with respect to chlorine-based gas. Therefore, the dry etching of the metal-containing film that is performed while using the resist upper layer film as a mask in the three-layer resist process is preferably performed using an etching gas mainly containing a chlorine-based gas. Subsequently, since the metal-containing film exhibits etching resistance with respect to oxygen-based gas, the dry etching of the resist underlayer film is preferably performed using an etching gas mainly containing an oxygen-based gas while using the metal-containing film as a mask. When an organic underlayer film is used as the resist underlayer film, the dry etching of the substrate to be processed is preferably performed using an etching gas mainly containing a fluorine-based gas while using the organic underlayer film as a mask, since the organic underlayer film exhibits etching resistance with respect to fluorine-based gas.

In the present invention, in such a multilayer resist process, a metal-containing film may be formed directly on the substrate to be processed as a resist underlayer film by using the above-described composition for forming a metal-containing film, or a resist underlayer film may be formed on the substrate to be processed and then a metal-containing film may be formed separately on it by using the above-described composition for forming a metal-containing film.

The present invention also provides, as a patterning process according to a three-layer resist process using the above-described composition for forming a metal-containing film, a patterning process for forming a pattern in a substrate to be processed, including the steps of:
(III-1) applying the above-described composition for forming a metal-containing film onto a substrate to be processed, followed by heating to form a metal-containing film;
(III-2) forming a silicon-containing resist middle layer film on the metal-containing film;
(III-3) forming a resist upper layer film on the silicon-containing resist middle layer film by using a photoresist material;
(III-4) subjecting the resist upper layer film to pattern exposure and then development with a developer to form a pattern in the resist upper layer film;
(III-5) transferring the pattern to the silicon-containing resist middle layer film by dry etching while using the resist upper layer film having the formed pattern as a mask;
(III-6) transferring the pattern to the metal-containing film by dry etching while using the silicon-containing resist middle layer film having the transferred pattern as a mask; and
(III-7) processing the substrate to be processed while using the metal-containing film having the formed pattern as a mask to form the pattern in the substrate to be processed.

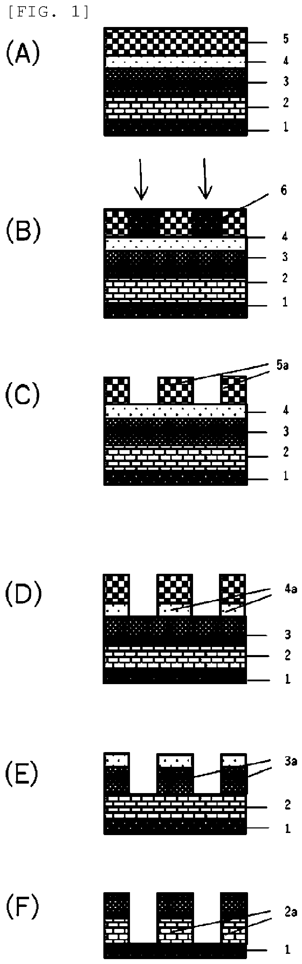

With reference to FIG. 1, a patterning process according to a three-layer resist process will be described. The present invention provides, as a patterning process according to a three-layer resist process using the above-described composition for forming a metal-containing film, a patterning process including: as in FIG. 1 (A), forming a metal-containing film 3 on a layer 2 to be processed on a substrate 1 to be processed by using the above-described composition for forming a metal-containing film, forming a silicon-containing resist middle layer film 4 on the metal-containing film by using a silicon-containing resist middle layer film material, and forming a resist upper layer film 5 on the silicon-containing resist middle layer film by using a photoresist material; subsequently, as in FIG. 1 (B), subjecting an exposure portion 6 of the resist upper layer film to pattern exposure and then, as in FIG. 1 (C), to development with a developer to form a resist upper layer film pattern 5a in the resist upper layer film; as in FIG. 1 (D), transferring a silicon-containing resist middle layer film pattern 4a to the silicon-containing resist middle layer film by dry etching while using the resist upper layer film having the formed pattern as a mask; as in FIG. 1 (E), transferring a metal-containing film pattern 3a to the metal-containing film by dry etching while using the silicon-containing resist middle layer film having the transferred pattern as a mask; as in FIG. 1 (F), forming a pattern 2a on the substrate 1 to be processed by processing the layer to be processed on the substrate to be processed while using the metal-containing film having the formed pattern as a mask.

The silicon-containing resist middle layer film in the three-layer resist process exhibits etching resistance with respect to a chlorine-based gas. Therefore, the dry etching of the metal-containing film that is performed while using the silicon-containing resist middle layer film as a mask in the three-layer resist process is preferably performed using an etching gas mainly containing a chlorine-based gas.

As the silicon-containing resist middle layer film in the three-layer resist process, a polysiloxane-based middle layer film is also favorably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthryl group for exposure at 248 nm or 157 nm, or a pendant phenyl group or a pendant light-absorbing group having a silicon-silicon bond for 193 nm exposure, and which is to be cross-linked by an acid or heat.

In addition, the present invention may also be a patterning process according to a four-layer resist process, further including a step of forming an organic thin film.

As a patterning process by way of a four-layer resist process using the above-described composition for forming a metal-containing film, the present invention can provide a patterning process for forming a pattern in a substrate to be processed, including the steps of:
applying the above-described composition for forming a metal-containing film onto a substrate to be processed, followed by heating to form a metal-containing film;
forming a silicon-containing resist middle layer film on the metal-containing film;
forming an organic thin film on the silicon-containing resist middle layer film;
forming a resist upper layer film on the organic thin film by using a photoresist material;
subjecting the resist upper layer film to pattern exposure and then development with a developer to form a pattern in the resist upper layer film;
transferring the pattern to the organic thin film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask to form the pattern in the substrate to be processed.

The organic thin film is not particularly limited, but is preferably a functional film having a function desired in the multilayer resist process, and can be, for example, an organic antireflective film (BARC) or an adhesive film.

For example, a patterning process by way of a four-layer resist process further including a step of forming an organic antireflective film (BARC) or an adhesive film as the organic thin film includes the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film as an organic thin film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask middle layer film may be formed instead of the silicon-containing resist middle layer film. In this case, a semiconductor device circuit pattern or the like can be formed on a substrate, at least, by:
forming a metal-containing film on a substrate to be processed by using the inventive composition for forming a metal-containing film;
forming an inorganic hard mask middle layer film selected from a silicon oxide film, a silicon nitride film, and a silicon oxynitride film on the metal-containing film;
forming a resist upper layer film on the inorganic hard mask middle layer film by using a photoresist composition;
forming a circuit pattern in the resist upper layer film;
transferring the pattern to the inorganic hard mask middle layer film while using the resist upper layer film having the formed pattern as a mask;
transferring the pattern to the metal-containing film while using the inorganic hard mask middle layer film having the formed pattern as a mask; and
furthermore, processing the substrate to be processed while using the metal-containing film having the formed pattern as a mask to form the pattern in the substrate to be processed.

The present invention provides, as a patterning process including a step of forming an inorganic hard mask middle layer film, a patterning process for forming a pattern in a substrate to be processed, including the steps of:
(IV-1) applying the above-described composition for forming a metal-containing film onto a substrate to be processed, followed by heating to form a metal-containing film;
(IV-2) forming an inorganic hard mask middle layer film selected from a silicon oxide film, a silicon nitride film, and a silicon oxynitride film on the metal-containing film;
(IV-3) forming an organic thin film on the inorganic hard mask middle layer film;
(IV-4) forming a resist upper layer film on the organic thin film by using a photoresist material;
(IV-5) subjecting the resist upper layer film to pattern exposure and then development with a developer to form a pattern in the resist upper layer film;
(IV-6) transferring the pattern to the organic thin film and the inorganic hard mask middle layer film by dry etching while using the resist upper layer film having the formed pattern as a mask;
(IV-7) transferring the pattern to the metal-containing film by dry etching while using the inorganic hard mask middle layer film having the transferred pattern as a mask; and
(IV-8) processing the substrate to be processed while using the metal-containing film having the formed pattern as a mask to form the pattern in the substrate to be processed.

As described above, when the inorganic hard mask middle layer film is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most favorably used as the inorganic hard mask middle layer film. Since the substrate temperature increases to 300 to 500°C when the SiON film is formed, the metal-containing film can preferably withstand a temperature of 300 to 500°C. The composition for forming a metal-containing film used in the present invention has high heat resistance and can withstand a high temperature of 300°C to 500°C. Thus, the metal-containing film formed by spin-coating and the inorganic hard mask middle layer film formed by the CVD method or the ALD method can be combined.

A photoresist film may be formed directly on the inorganic hard mask middle layer film as the resist upper layer film. Alternatively, as described above, an organic antireflective film (BARC) or an organic thin film, such as an adhesive film, may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to CVD or ALD.

In a case where the photoresist upper layer film is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the resist upper layer film is to be formed by a deposition treatment according to a CVD method or an ALD method, the photoresist composition is a metal-oxide-containing film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal-oxide-containing film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal-oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a high-frequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the metal-containing film is etched while using the obtained silicon-containing resist middle layer film pattern or inorganic hard mask middle layer film pattern as a mask. The etching of the metal-containing film is preferably performed using an etching gas mainly containing a chlorine-based gas.

The subsequent etching of the substrate to be processed may also be performed according to a usual manner. For example, in the case of a substrate to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the substrate to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the inventive patterning processes, using the composition for forming a metal-containing film, it is preferable to use a substrate to be processed having a structure or step having a height of 30 nm or more. As stated above, the inventive composition for forming a metal-containing film is excellent in filling and planarizing properties, and therefore, a flat metal-containing film can be formed even when the substrate to be processed has a structure or step (irregularities) having a height of 30 nm or more. The height of the structure or step that the substrate to be processed has is preferably 30 nm or more, more preferably 50 nm or more, and more preferably 100 nm or more. In a method for processing a stepped substrate having a pattern of the above-described height, by forming a film of the inventive composition for forming a metal-containing film to perform filling and planarization, it is possible to achieve a uniform film thickness in the subsequently formed silicon-containing resist middle layer film and resist upper layer film, and therefore, exposure depth margin (DOF) at the time of photolithography can be ensured easily, and this is extremely favorable.

Furthermore, the present invention can further include a step of forming an organic underlayer film by using an organic underlayer film material. As such a patterning process according to a multilayer resist process using a composition for forming a metal-containing film, the present invention provides a patterning process including the steps of:
forming a metal-containing film on a substrate to be processed by using the above-described composition for forming a metal-containing film;
forming an organic underlayer film on the metal-containing film by using an organic underlayer film material;
forming a silicon-containing resist middle layer film on the organic underlayer film by using a silicon-containing resist middle layer film material;
forming an organic antireflective film (BARC) or an adhesive film on the silicon-containing resist middle layer film as necessary;
forming a resist upper layer film on the silicon-containing resist middle layer film, on the BARC, or on the adhesive film by using a photoresist material;
subjecting the resist upper layer film to pattern exposure and then development with a developer to form a pattern in the resist upper layer film;
transferring the pattern to the BARC or the adhesive film and the silicon-containing resist middle layer film by dry etching while using the resist upper layer film having the formed pattern as a mask;
transferring the pattern to the organic underlayer film by dry etching while using the silicon-containing resist middle layer film having the transferred pattern as a mask;
transferring the pattern to the metal-containing film while using the organic underlayer film as a mask; and
processing the substrate to be processed while using the metal-containing film having the formed pattern as a mask to form the pattern in the substrate
to be processed.

As the organic underlayer film material that can be used for the organic underlayer film, it is possible to use: materials already known as materials for an underlayer film for three-layer resist methods or two-layer resist methods using a silicon resist composition; 4,4'-(9-fluorenylidene) bisphenol novolak resin (molecular weight: 11,000) disclosed in JP2005-128509A; and also many resins including novolak resins, known as resist underlayer film materials for two-layer resist methods and three-layer resist methods. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic underlayer film can be formed on the metal-containing film by using a composition solution and by a spin-coating method or the like in the same manner as the photoresist composition. After forming the organic underlayer film by a spin-coating method or the like, it is desirable to bake the film in order to evaporate the organic solvent. The baking temperature is preferably 80 to 400°C, and the baking time is preferably 10 to 300 seconds.

Instead of the organic underlayer film, it is also possible to adopt an organic hard mask formed by a CVD method or an ALD method.

The organic underlayer film in the multilayer resist process described above exhibits etching resistance with respect to chlorine-based gas. Therefore, the dry etching of the metal-containing film that is performed while using the organic underlayer film as a mask in the multilayer resist process is preferably performed using an etching gas mainly containing a chlorine-based gas.

The present invention also provides, as a patterning process according to a different multilayer resist process using the above-described composition for forming a metal-containing film, a patterning process for forming a pattern in a substrate to be processed, including the steps of:
(V-1) applying the above-described composition for forming a metal-containing film onto a substrate to be processed, followed by heating to form a metal-containing film;
(V-2) forming an organic middle layer film on the metal-containing film;
(V-3) forming a silicon-containing resist middle layer film or a combination of an organic thin film and an inorganic hard mask middle layer film selected from a silicon oxide film, a silicon nitride film, and a silicon oxynitride film on the organic middle layer film;
(V-4) forming a resist upper layer film on the silicon-containing resist middle layer film or the organic thin film by using a photoresist material;
(V-5) subjecting the resist upper layer film to pattern exposure and then development with a developer to form a pattern in the resist upper layer film;
(V-6) transferring the pattern to the silicon-containing resist middle layer film or the organic thin film and the inorganic hard mask middle layer film by dry etching while using the resist upper layer film having the formed pattern as a mask;
(V-7) transferring the pattern to the organic middle layer film by dry etching while using the silicon-containing resist middle layer film or the inorganic hard mask middle layer film having the transferred pattern as a mask;
(V-8) transferring the pattern to the metal-containing film by dry etching while using the organic middle layer film as a mask; and
(V-9) processing the substrate to be processed while using the metal-containing film having the formed pattern as a mask to form the pattern in the substrate to be processed.

The patterning process according to the above-described multilayer resist process using the inventive composition for forming a metal-containing film makes it possible to form a fine pattern in a body to be processed with high accuracy.

### <Tone-Reversal Patterning Process Using Composition for Forming Metal-Containing Film>

The present invention also provides, as a tone-reversal patterning process using the above-described composition for forming a metal-containing film, a tone-reversal patterning process for forming a pattern in a substrate to be processed, including the steps of:
(VI-1) forming a resist underlayer film on a substrate to be processed;
(VI-2) forming a silicon-containing resist middle layer film or a combination of an organic thin film and an inorganic hard mask middle layer film selected from a silicon oxide film, a silicon nitride film, and a silicon oxynitride film on the resist underlayer film;
(VI-3) forming a resist upper layer film on the silicon-containing resist middle layer film or the combination of the inorganic hard mask middle layer film and the organic thin film by using a photoresist material;
(VI-4) subjecting the resist upper layer film to pattern exposure and then development with a developer to form a pattern in the resist upper layer film;
(VI-5) transferring the pattern to the silicon-containing resist middle layer film or the organic thin film and the inorganic hard mask middle layer film by dry etching while using the resist upper layer film having the formed pattern as a mask;
(VI-6) transferring the pattern to the resist underlayer film by dry etching while using the silicon-containing resist middle layer film or the inorganic hard mask middle layer film having the transferred pattern as a mask;
(VI-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(VI-8) etching back the metal-containing film covering the resist underlayer film having the formed pattern by a chemical stripper or dry etching to expose an upper surface of the resist underlayer film having the formed pattern;
(VI-9) removing the silicon-containing resist middle layer film or the inorganic hard mask middle layer film remaining on the upper surface of the resist underlayer film by dry etching;
(VI-10) removing, by dry etching, the resist underlayer film having the formed pattern with an exposed surface to form a reverse pattern of an original pattern on the metal-containing film; and
(VI-11) processing the substrate to be processed while using the metal-containing film having the formed reverse pattern as a mask to form the reverse pattern in the substrate to be processed.

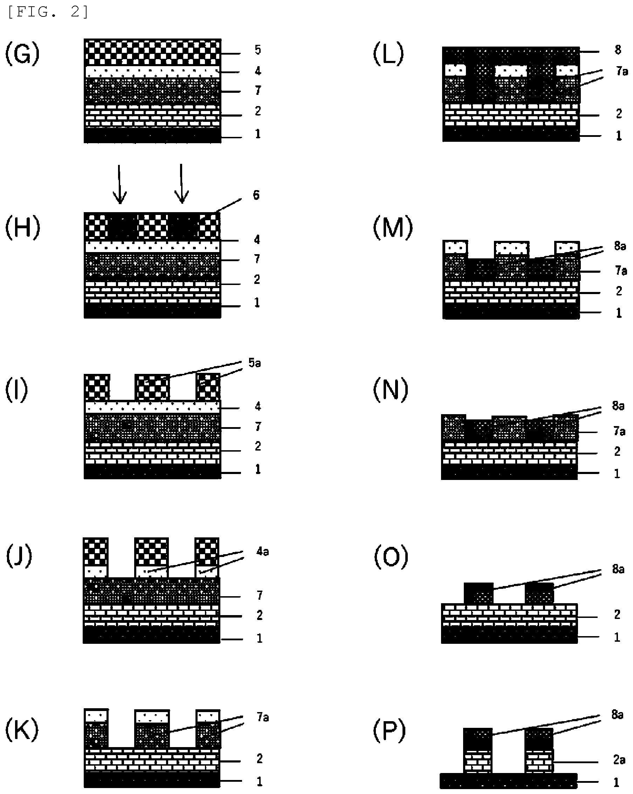

With reference to FIG. 2, a tone-reversal patterning process using a composition for forming a metal-containing film will be described. The present invention provides, as a tone-reversal patterning process using such a composition for forming a metal-containing film, a tone-reversal patterning process including the steps of: as in FIG. 2 (G), forming a resist underlayer film 7, formed from a coating-type organic underlayer film material or the like, on a layer 2 to be processed on a substrate 1 to be processed, forming a silicon-containing resist middle layer film 4 or a combination of an organic thin film and an inorganic hard mask middle layer film selected from a silicon oxide film, a silicon nitride film, and a silicon oxynitride film on the resist underlayer film 7, and forming a resist upper layer film 5 on the silicon-containing resist middle layer film 4 or the combination of the organic thin film and the inorganic hard mask middle layer film by using a photoresist material; subsequently, as in FIG. 2 (H), subjecting an exposure portion 6 of the resist upper layer film to pattern exposure, then, as in FIG. 2 (I), to development with a developer to form a resist upper layer film pattern 5a in the resist upper layer film; as in FIG. 2 (J), transferring a silicon-containing resist middle layer film pattern 4a or an inorganic hard mask middle layer film pattern to the silicon-containing resist middle layer film 4 or the organic thin film and the inorganic hard mask middle layer film by dry etching while using the resist upper layer film having the formed pattern as a mask; as in FIG. 2 (K), transferring a resist underlayer film pattern 7a to the resist underlayer film by dry etching while using the silicon-containing resist middle layer film having the transferred pattern or the inorganic hard mask middle layer film having the transferred pattern as a mask; as in FIG. 2 (L), covering the resist underlayer film having the formed pattern with a metal-containing film 8 by using the above-described composition for forming a metal-containing film to fill a space between the resist underlayer film patterns 7a with the metal-containing film 8; as in FIG. 2 (M), etching back the metal-containing film 8 covering the resist underlayer film having the formed pattern by a chemical stripper or dry etching to form a reversed metal-containing film pattern 8a to the resist underlayer film pattern and expose an upper surface of the resist underlayer film having the formed pattern; as in FIG. 2 (N), removing, by dry etching, the silicon-containing resist middle layer film or the inorganic hard mask middle layer film remaining on the upper surface of the resist underlayer film pattern 7a; as in FIG. 2 (O), removing, by dry etching, the resist underlayer film having the formed pattern with the exposed surface to form a reverse pattern of the original pattern in the metal-containing film; and as in FIG. 2 (P), processing the layer to be processed while using the metal-containing film having the formed reverse pattern as a mask to form a reverse pattern 2a in the layer to be processed.

As described above, when the resist underlayer film is formed on the substrate to be processed, the resist underlayer film can be formed by a method using a coating-type resist underlayer film material, a CVD method, an ALD method, or the like. Examples of the coating-type resist underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

In the tone-reversal patterning process, after the obtained resist underlayer film pattern is covered with the composition for forming a metal-containing film, it is preferable to remove the metal-containing film by using a dry etching gas mainly containing a chlorine-based gas so as to expose the upper surface of the resist underlayer film pattern. Thereafter, the silicon-containing resist middle layer film or the inorganic hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat metal-containing film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film of the inventive composition for forming a metal-containing film, inversion/transfer of the pattern can be performed with a high degree of accuracy, which is very desirable. Reversing the resist underlayer film pattern by using the composition for forming a metal-containing film allows a desired resist pattern to be formed on a film to be processed with a high degree of accuracy due to the excellence in resistance in dry etching using a fluorocarbon-based gas relative to the resist underlayer film using a previously-known coating-type resist underlayer film material.

### EXAMPLES

The present invention is more specifically described below with reference to Synthesis Examples, Comparative Synthesis Examples, Examples, and Comparative Examples. However, the present invention is not limited to these Examples.

### [Synthesis Examples]

In the following Synthesis Examples, the following organic group starting material group G ((G1) to (G11)) and silicon-containing organic group starting material group H ((H1) and (H2)) were used.

The organic group starting material group G ((G1) to (G11)) is shown below.

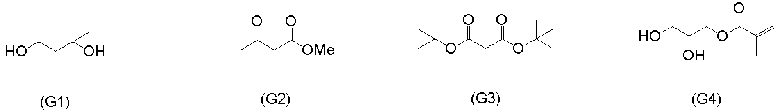

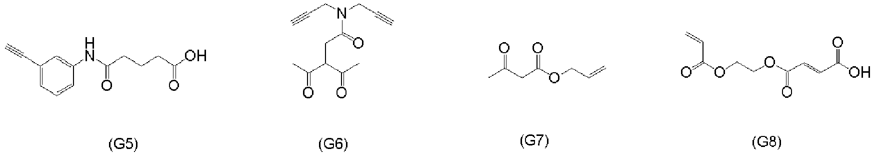

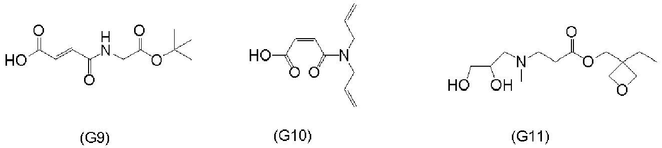

The silicon-containing organic group starting material group H ((H1) and (H2)) is shown below.

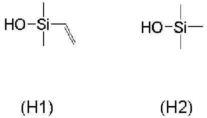

As a metal source M, the following metal compounds were used.
(M1): titanium tetraisopropoxide (377996 available from Sigma-Aldrich Corp)
(M2): Zr(OnBu)₄: zirconium(IV) tetrabutoxide (80 mass% solution in 1-butanol) (Z0016 available from Tokyo Chemical Industry Co., Ltd.)
(M3): Hf(OnBu)₄: hafnium(IV) n-butoxide (667943 available from Sigma-Aldrich Corp)

### [Synthesis Example 1] Synthesis of Compound (A-1) for Forming Metal-Containing Film

Under a nitrogen atmosphere, into 40.5 g of a solution of 28.4 g of titanium tetraisopropoxide (M1) in n-butanol, while stirring, 54.5 g of a solution of 1.6 g of deionized water in n-butanol was added dropwise at room temperature over 2 hours. To the obtained solution, 11.2 g of the organic group starting material group (G1) was added, and the mixture was agitated at room temperature for 30 minutes. After the solution was concentrated under reduced pressure at 30°C, it was further heated to 60°C and heating was continued under reduced pressure to generate no distillate. When a distillate was no longer observed, 69.0 g of a PGMEA/PGME (ratio by mass: 70/30) solution was added thereto and heated under reduced pressure at 40°C until no isopropanol (IPA) was distilled. Thus, a solution of a compound (A-1) for forming a metal-containing film in PGMEA/PGME was obtained. The concentration of the components in the solution other than the solvent was 17% by mass.

### [Synthesis of Compounds (A-2) to (A-11)]

The compounds (A-2) to (A-11) shown in Table 1 were obtained under the same reaction conditions as in Synthesis Example 1, except that the metal source M and the compound group G were used at the charging amounts shown in Table 1.

**[Table 1]**

| Synthesis Example | Metal starting material | | Compound group G | | Compound |
|---|---|---|---|---|---|
| | Starting material | g | Starting material | g | |
| 1 | M1 | 28.4 | G1 | 11.2 | A-1 |
| 2 | M2 | 57.5 | G2 | 13.6 | A-2 |
| 3 | M3 | 54.9 | G3 | 25.1 | A-3 |
| 4 | M1 | 28.4 | G4 | 15.8 | A-4 |
| 5 | M2 | 57.5 | G5 | 50.1 | A-5 |
| 6 | M3 | 54.9 | G6 | 26.5 | A-6 |
| 7 | M2 | 57.5 | G7 | 17.4 | A-7 |
| 8 | M2 | 57.5 | G8 | 56.4 | A-8 |
| 9 | M2 | 57.5 | G9 | 59.6 | A-9 |
| 10 | M2 | 57.5 | G10 | 53.0 | A-10 |
| 11 | M2 | 57.5 | G11 | 32.4 | A-11 |

### [Synthesis Example 2] Synthesis of Compound (A-12) for Forming Metal-Containing Film

Under a nitrogen atmosphere, 12.6 g of titanium tetraisopropoxide (M1) was dissolved in 23.4 g of a PGMEA/PGME (ratio by mass: 70/30) solution. The reaction temperature was raised to 50°C while stirring, and 6.5 g of the compound H1 was added dropwise to the solution. After the addition, stirring was continued for 2 hours at a reaction temperature of 60°C. Subsequently, a mixture obtained by suspending 5.4 g of the compound G4 in 10.8 g of a PGMEA/PGME (ratio by mass: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-12) for forming a metal-containing film in PGMEA/PGME was obtained. The concentration of the components in the solution other than the solvent was 15% by mass.

### [Synthesis of Compounds (A-12) to (A-15)]

The compounds (A-12) to (A-15) shown in Table 2 were obtained under the same reaction conditions as in Synthesis Example 2, except that the metal source M, the compound group G, and the compound group H were used at the charging amounts shown in Table 2.

**[Table 2]**

| Synthesis Example | Metal starting material | | Compound group G | | Compound group H | | Compound |
|---|---|---|---|---|---|---|---|
| | Starting material | g | Starting material | g | Starting material | g | |
| 12 | M1 | 12.6 | G4 | 5.4 | H1 | 6.5 | A-12 |
| 13 | M2 | 20.9 | G5 | 20.4 | H2 | 6.5 | A-13 |
| 14 | M3 | 20.3 | G6 | 7.8 | H2 | 6.5 | A-14 |
| 15 | M2 | 20.9 | G7 | 6.4 | H2 | 6.5 | A-15 |

### [Crosslinking Agents B-1 to B-14)]

Crosslinking agents (B-1) to (B-14), used in compositions for forming a metal-containing film, are shown below.
As B-6, -7, and -13, the following were used.
B-6: ETERNACOLL (registered trademark) OXIPA available from UBE Corporation
B-7: OXT-121 available from TOAGOSEI CO., LTD.
B-13: ETERNACOLL (registered trademark) OXBP available from UBE Corporation

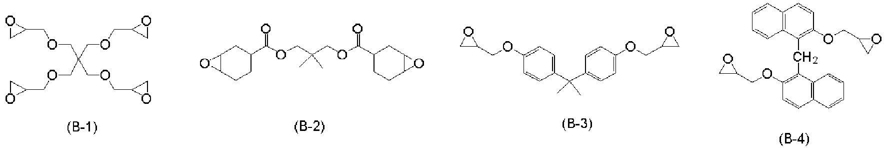

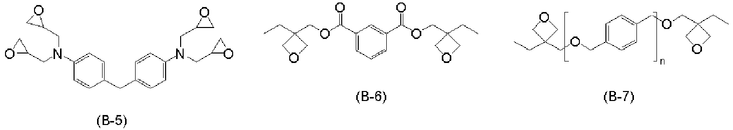

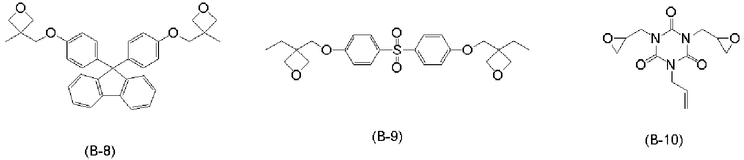

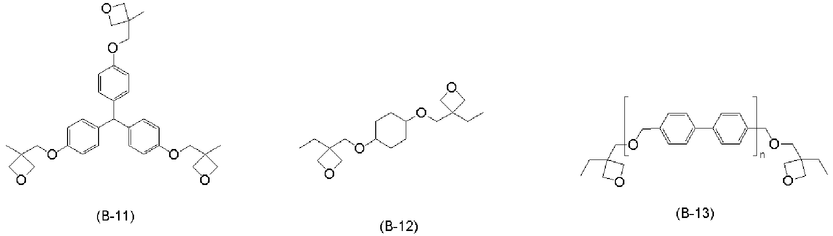

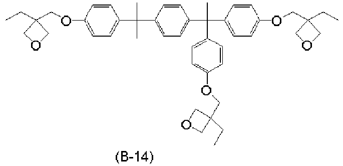

### [Crosslinking Agents (R-1 to R-6) for Comparative Examples]

Crosslinking agents (R-1) to (R-6) for Comparative Examples, used in comparative compositions for forming a metal-containing film, are shown below. As R-2, OXT-212, available from TOAGOSEI CO., LTD., was used.

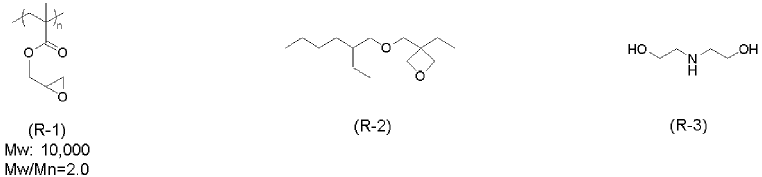

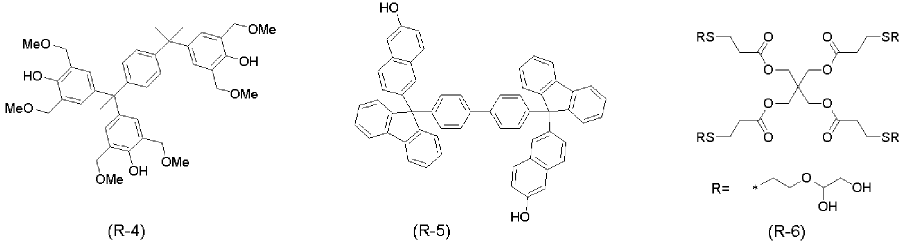

### [Preparation of Composition (MUL-1) for Forming Metal-Containing Film]

The compound (A-1) for forming a metal-containing film was dissolved in a mixed solvent of propylene glycol monomethyl ether acetate (PGMEA) and propylene glycol monomethyl ether (PGME) in the proportion shown in Table 3, and the solution was filtered through a 0.02-µm membrane filter to prepare a composition (MUL-1) for forming a metal-containing film.

### [Preparation of Compositions (MUL-2 to -17) for Forming Metal-Containing Film and Compositions (Comparative MUL-1 to -10) for Forming Metal-Containing Film for Comparative Examples]

Each chemical liquid was prepared in the same manner as MUL-1, except that the type and the contained amount of each component were as shown in Table 3. In Table 3, "-" indicates that the component was not used. As a high-boiling-point solvent (D-1), ethylene glycol dibenzyl ether (boiling point: 364°C) was used, and for an acid generator (TAG), the following formula (E-1) was used.

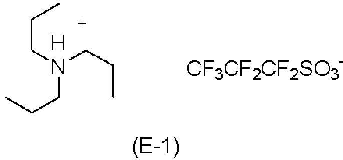

**[Table 3]**

| Composition for forming metal-containing film | (A) Compound for forming metal-containing film (parts by mass) | (B) Crosslinking agent (parts by mass) | Additive (parts by mass) | Solvent (parts by mass) |
|---|---|---|---|---|
| MUL-1 | A-1 (7) | B-1 (2) | - | PGMEA/PGME (64/27) |
| MUL-2 | A-2 (7) | B-2 (2) | - | PGMEA/PGME (64/27) |
| MUL-3 | A-3 (7) | B-3 (2) | - | PGMEA/PGME (64/27) |
| MUL-4 | A-4 (7) | B-4 (2) | - | PGMEA/PGME (64/27) |
| MUL-5 | A-5 (7) | B-5 (2) | - | PGMEA/PGME (64/27) |
| MUL-6 | A-6 (7) | B-6 (2) | - | PGMEA/PGME (64/27) |
| MUL-7 | A-7 (7) | B-7 (2) | - | PGMEA/PGME (64/27) |
| MUL-8 | A-8 (7) | B-8 (2) | - | PGMEA/PGME (64/27) |
| MUL-9 | A-9 (7) | B-9 (2) | - | PGMEA/PGME (64/27) |
| MUL-10 | A-10 (7) | B-10 (2) | - | PGMEA/PGME (64/27) |
| MUL-11 | A-11 (7) | B-7 (2) | - | PGMEA/PGME (64/27) |
| MUL-12 | A-12 (7) | B-11 (2) | - | PGMEA/PGME (64/27) |
| MUL-13 | A-13 (7) | B-12 (2) | - | PGMEA/PGME (64/27) |
| MUL-14 | A-14 (7) | B-13 (2) | - | PGMEA/PGME (62/27) |
| MUL-15 | A-15 (7) | B-14 (2) | - | PGMEA/PGME (64/27) |
| MUL-16 | A-7 (7) | B-7 (2) | D-1 (3) | PGMEA/PGME (64/27) |
| MUL-17 | A-7 (7) | B-7 (2) | E-1 (0.2) | PGMEA/PGME (64/27) |
| Comparative MUL-1 | A-1 (7) | - | - | PGMEA/PGME (65/28) |
| Comparative MUL-2 | A-7 (7) | - | - | PGMEA/PGME (65/28) |
| Comparative MUL-3 | A-3 (7) | - | - | PGMEA/PGME (65/28) |
| Comparative MUL-4 | A-2 (7) | R-1 (2) | - | PGMEA/PGME (64/27) |
| Comparative MUL-5 | A-2 (7) | R-2 (2) | - | PGMEA/PGME (64/27) |
| Comparative MUL-6 | A-2 (7) | R-3 (2) | - | PGMEA/PGME (64/27) |
| Comparative MUL-7 | A-2 (7) | R-4 (2) | - | PGMEA/PGME (64/27) |
| Comparative MUL-8 | A-2 (7) | R-5 (2) | - | PGMEA/PGME (64/27) |
| Comparative MUL-9 | A-2 (7) | R-6 (2) | - | PGMEA/PGME (64/27) |
| Comparative MUL-10 | R-5 (5) | - | - | PGMEA (95) |

### [Film Thickness Uniformity Evaluation]

Each of the compositions (MUL-1 to -17 and comparative MUL-1 to -9) for forming a resist underlayer film prepared above was respectively applied onto a 300-mm silicon substrate and baked at 350°C for 60 seconds. Then, the film thickness of 225 points of the 300-mm wafer from the central portion to the peripheral portion of the substrate were measured, and when the difference in film thickness between the maximum film thickness and the minimum film thickness out of the measured thicknesses was less than 3% of the average film thickness (b), the composition was evaluated as A (very good), when 3% or more and less than 5%, B (good), and when 5% or more, C (poor) .

In Comparative Example 1-9, a precipitate was generated after preparing the above-described sample with using comparative MUL-9, and therefore, the evaluation was terminated. It is conjectured that, since the compound (R-6) used as the crosslinking agent (B) contained many hydroxy groups, the compound reacted with the metal compound, and the precipitate was generated.

**[Table 4]**

| Example | Composition for forming metal-containing film | Baking temperature | Film thickness uniformity |
|---|---|---|---|
| Example 1-1 | MUL-1 | 350°C | B |
| Example 1-2 | MUL-2 | 350°C | A |
| Example 1-3 | MUL-3 | 350°C | A |
| Example 1-4 | MUL-4 | 350°C | A |
| Example 1-5 | MUL-5 | 350°C | A |
| Example 1-6 | MUL-6 | 350°C | A |
| Example 1-7 | MUL-7 | 350°C | A |
| Example 1-8 | MUL-8 | 350°C | A |
| Example 1-9 | MUL-9 | 350°C | A |
| Example 1-10 | MUL-10 | 350°C | A |
| Example 1-11 | MUL-11 | 350°C | A |
| Example 1-12 | MUL-12 | 350°C | A |
| Example 1-13 | MUL-13 | 350°C | B |
| Example 1-14 | MUL-14 | 350°C | A |
| Example 1-15 | MUL-15 | 350°C | A |
| Example 1-16 | MUL-16 | 350°C | A |
| Example 1-17 | MUL-17 | 350°C | A |
| Comparative Example 1-1 | Comparative MUL-1 | 350°C | C |
| Comparative Example 1-2 | Comparative MUL-2 | 350°C | C |
| Comparative Example 1-3 | Comparative MUL-3 | 350°C | C |
| Comparative Example 1-4 | Comparative MUL-4 | 350°C | C |
| Comparative Example 1-5 | Comparative MUL-5 | 350°C | C |
| Comparative Example 1-6 | Comparative MUL-6 | 350°C | B |
| Comparative Example 1-7 | Comparative MUL-7 | 350°C | B |
| Comparative Example 1-8 | Comparative MUL-8 | 350°C | B |

The inventive compositions for forming a metal-containing film (Examples 1-1 to 1-17) achieved excellent results regarding film thickness uniformity. This is conjectured to be because the metal compound (A) and the crosslinking agent (B) reacted favorably. In particular, the compositions containing a crosslinking agent (B) having a cyclic structure exhibited very good film thickness uniformity. On the other hand, in Comparative Examples 1-1 to 1-3, in which the film was formed with only the compound for forming a metal-containing film, the film thickness uniformity after the high-temperature baking was insufficient. Meanwhile, in Comparative Example 1-4, the comparative crosslinking agent R-1 was a polymer having a cyclic ether structure in the repeating unit and had high reactivity, and therefore, had a large proportion of self-crosslinking. It is conjectured that, for this reason, the reaction with the metal compound was insufficient and heat resistance was degraded. In Comparative Example 1-5, the comparative crosslinking agent R-2 was monofunctional and had insufficient heat resistance, and it is conjectured that, therefore, the film thickness uniformity was not improved. In Comparative Examples 1-6 and 1-7, where polyfunctional crosslinking agents (R-3 and R-4) were used, and in Comparative Example 1-8, where the crosslinking agent (R-5), excellent in heat resistance, was used, some improvement in film thickness uniformity was observed compared to Comparative Example 1-1, where the formulation using only the metal compound was used.

### [Filling Property Evaluation]

Each of the compositions (MUL-1 to -17 and comparative MUL-1 to -8) prepared above was respectively applied onto an SiO₂ wafer substrate (substrate A) having three kinds of dense line-and-space patterns, followed by heating at 350°C for 60 seconds by using a hot plate to form a metal-containing film having a film thickness of 80 nm.
Pattern A: line width = 60 nm; line depth = 120 nm; distance between the centers of two adjacent lines = 120 nm
Pattern B: line width = 50 nm; line depth = 120 nm; distance between the centers of two adjacent lines = 100 nm
Pattern C: line width = 40 nm; line depth = 120 nm; distance between the centers of two adjacent lines = 80 nm

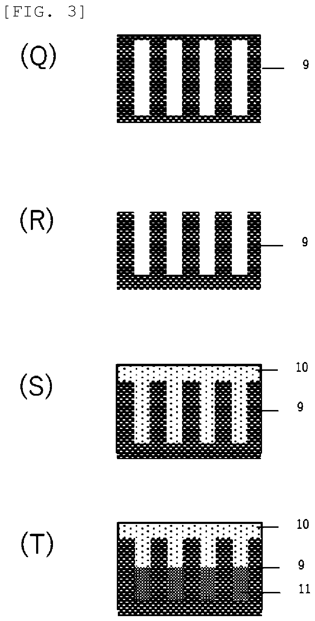

The substrate A used was a base substrate 9 (SiO₂ wafer substrate) having a dense line-and-space pattern shown in FIG. 3 (Q) (downward view) and (R) (cross-sectional view). The cross-sectional shape of each of the wafer substrates obtained in the filling property evaluation was observed using an electron microscope (S-4700) manufactured by Hitachi, Ltd., and the presence/absence of voids (gaps) at the bottom of the metal-containing film filling the space between the lines was confirmed. Table 5 shows the results.

When a composition for forming a metal-containing film having a desirable filling property is used, in this evaluation, the bottom of the metal-containing film filling the space between the lines of the base substrate 9 having the dense line-and-space pattern is filled with a void-free metal-containing film 10, as shown in FIG. 3 (S). When a composition for forming a metal-containing film having a poor filling property is used, voids 11 are generated at the bottom of the metal-containing film filling the space between the lines, as shown in FIG. 3 (T).

Preferably, the pattern A can be filled, more preferably, the pattern B, having a finer pattern, can be filled, and further preferably, the pattern C, having an even finer pattern, can be filled.

**[Table 5]**

| Example | Composition for forming metal-containing film | Baking temperature | Filling property | Filling property | Filling property |
|---|---|---|---|---|---|
| | | | 60 LS | 50 LS | 40 LS |
| Example 2-1 | MUL-1 | 350°C | Good | Poor | Poor |
| Example 2-2 | MUL-2 | 350°C | Good | Poor | Poor |
| Example 2-3 | MUL-3 | 350°C | Good | Good | Poor |
| Example 2-4 | MUL-4 | 350°C | Good | Good | Good |
| Example 2-5 | MUL-5 | 350°C | Good | Good | Good |
| Example 2-6 | MUL-6 | 350°C | Good | Good | Good |
| Example 2-7 | MUL-7 | 350°C | Good | Good | Good |
| Example 2-8 | MUL-8 | 350°C | Good | Good | Good |
| Example 2-9 | MUL-9 | 350°C | Good | Good | Good |
| Example 2-10 | MUL-10 | 350°C | Good | Good | Good |
| Example 2-11 | MUL-11 | 350°C | Good | Good | Good |
| Example 2-12 | MUL-12 | 350°C | Good | Good | Poor |
| Example 2-13 | MUL-13 | 350°C | Good | Good | Poor |
| Example 2-14 | MUL-14 | 350°C | Good | Good | Poor |
| Example 2-15 | MUL-15 | 350°C | Good | Good | Poor |
| Example 2-16 | MUL-16 | 350°C | Good | Good | Good |
| Example 2-17 | MUL-17 | 350°C | Good | Good | Poor |
| Comparative Example 2-1 | Comparative MUL-1 | 350°C | Poor | Poor | Poor |
| Comparative Example 2-2 | Comparative MUL-2 | 350°C | Good | Poor | Poor |
| Comparative Example 2-3 | Comparative MUL-3 | 350°C | Poor | Poor | Poor |
| Comparative Example 2-4 | Comparative MUL-4 | 350°C | Poor | Poor | Poor |
| Comparative Example 2-5 | Comparative MUL-5 | 350°C | Poor | Poor | Poor |
| Comparative Example 2-6 | Comparative MUL-6 | 350°C | Poor | Poor | Poor |
| Comparative Example 2-7 | Comparative MUL-7 | 350°C | Poor | Poor | Poor |
| Comparative Example 2-8 | Comparative MUL-8 | 350°C | Poor | Poor | Poor |

As shown in Table 5, in Examples 2-1 to 2-17, where the inventive compositions (MUL-1 to -17) for forming a metal-containing film were used, it was successfully confirmed that, regarding the pattern A, it was possible to fill the dense line-and-space pattern without voids being generated at the bottom of the pattern even after the baking at 350°C, and that the compositions had a favorable filling property even under high-temperature baking conditions.

In particular, in Examples 2-4 to 2-11, where the metal compounds (A-4 to A-11) having a ligand including a crosslinking group were used, excellent filling property was also exhibited in the finer pattern of the pattern B and the pattern C. This is conjectured to be because the heat resistance of the metal compound was improved by the metal compound having a ligand containing a crosslinking group structure, and the reactivity with the crosslinking agent (B) was further improved. In the Examples where the metal compounds (A-12 to A-15) in which a hydrolysable group was substituted with a silicon-containing group was used, filling property was insufficient in the pattern C, which was even finer. This is conjectured to be because the reaction with the crosslinking agent (B) is promoted more when the crosslinking agent has an alkoxy group contained as a hydrolysable group.

Meanwhile, the composition (MUL-3) for forming a metal-containing film, in which the crosslinking agent (B) contained an aromatic ring structure, exhibited better filling property in the pattern B than the compositions (MUL-1 and -2) for forming a metal-containing film, in which the crosslinking agent (B) does not contain an aromatic ring structure. It is conjectured that this is because the heat resistance of the crosslinking agent was improved by the crosslinking agent (B) containing an aromatic ring structure, and the reactivity with the metal compound (A) was further improved.

Regarding MUL-17, the generation of voids was observed in the pattern C. It is conjectured that, by an acid generator being contained, the self-condensation of the metal compound (A) was promoted and the reactivity with the crosslinking agent (B) was degraded, and therefore, the volume shrinkage of the metal compound was great in the fine substrate (pattern C), where heat from the substrate is more easily conducted, so that voids were generated.

Comparative MUL-2 did not contain the crosslinking agent (B), but contained the metal compound (A-7), which has a ligand including a crosslinking group structure, and it is conjectured that the heat resistance of the metal compound was therefore improved, and the pattern A was successfully filled without voids. On the other hand, regarding comparative MUL-1 and comparative MUL-3, which did not contain the crosslinking agent (B) and were constituted from metal compounds not having a ligand containing a crosslinking group structure, the generation of voids was observed in every pattern.

In Comparative Examples 2-4 to 2-8, where used were the compositions (comparative MUL-4 to -8) for forming a metal-containing film in which the crosslinking agent (B) did not contain two or more cyclic ether structures per molecule, the structures having 2 to 13 carbon atoms, unlike the inventive compositions for forming a metal-containing film, voids were observed at the bottom of the pattern after the baking at 350°C, in the cases of the pattern B and the pattern C, which were finer. It is conjectured that in these cases, the reactivity between the metal compound (A) and the crosslinking agent (B) was poor, and the heat resistance of the metal-containing film was insufficient, and therefore, volume shrinkage due to high-temperature baking was great, so that voids were generated.

### [Etching Resistance Evaluation]

Each of the compositions (MUL-1 to -17 and comparative MUL-1 to -8 and -10) for forming a metal-containing film was applied onto a silicon substrate and heated by using a hot plate at 350°C for 60 seconds to form a metal-containing film having a thickness of 80 nm, and the film thickness "a" was measured. Subsequently, each etching was performed under the following conditions (conditions 1 and conditions 2) by using an etching apparatus TE8500 manufactured by Tokyo Electron Ltd., and the film thickness "b" was measured. Then, the film thickness etched in 1 minute was calculated as an etching rate (nm/min) from the film thickness etched (film thickness "b" - film thickness "a") in the specified time.

In the case of the conditions 1, the evaluation A (very good) was given when the etching rate was 50 nm/min or lower, B (good) when higher than 50 nm/min and 70 nm/min or lower, and C (poor) when higher than 70 nm/min.

In the case of the conditions 2, the evaluation A (very good) was given when the etching rate was 50 nm/min or lower, B (good) when higher than 50 nm/min and 70 nm/min or lower, and C (poor) when higher than 70 nm/min.

The results are shown in Table 6.
Dry etching conditions 1
   Pressure: 200 mT
   RF power: 300 W
   CF₄ gas flow rate: 100 sccm
   Time: 20 sec
Dry etching conditions 2
   Pressure: 500 mT
   RF power: 100 W
   O₂ gas flow rate: 30 sccm
   N₂ gas flow rate: 270 sccm
   Time: 20 sec

**[Table 6]**

| Example | Composition for forming metal-containing film | Etching rate (nm/min) | Etching rate (nm/min) |
|---|---|---|---|
| | | CF₄ | O2 |
| Example 3-1 | MUL-1 | A | A |
| Example 3-2 | MUL-2 | A | A |
| Example 3-3 | MUL-3 | A | A |
| Example 3-4 | MUL-4 | A | A |
| Example 3-5 | MUL-5 | B | B |
| Example 3-6 | MUL-6 | A | A |
| Example 3-7 | MUL-7 | A | A |
| Example 3-8 | MUL-8 | B | B |
| Example 3-9 | MUL-9 | B | B |
| Example 3-10 | MUL-10 | A | A |
| Example 3-11 | MUL-11 | A | A |
| Example 3-12 | MUL-12 | A | A |
| Example 3-13 | MUL-13 | B | B |
| Example 3-14 | MUL-14 | A | A |
| Example 3-15 | MUL-15 | A | A |
| Example 3-16 | MUL-16 | A | A |
| Example 3-17 | MUL-17 | A | A |
| Comparative Example 3-1 | Comparative MUL-1 | A | A |
| Comparative Example 3-2 | Comparative MUL-2 | A | A |
| Comparative Example 3-3 | Comparative MUL-3 | A | A |
| Comparative Example 3-4 | Comparative MUL-4 | B | B |
| Comparative Example 3-5 | Comparative MUL-5 | A | A |
| Comparative Example 3-6 | Comparative MUL-6 | A | A |
| Comparative Example 3-7 | Comparative MUL-7 | A | A |
| Comparative Example 3-8 | Comparative MUL-8 | A | A |
| Comparative Example 3-9 | Comparative MUL-10 | C | C |

As shown in Table 6, it was shown that, in Examples 3-1 to 3-17, where the inventive compositions (MUL-1 to -17) for forming a metal-containing film were used, excellent dry etching resistance was exhibited for each of fluorine gas and oxygen gas. In particular, it was shown that compositions for forming a metal-containing film containing a metal compound having a polydentate ligand exhibit extremely good dry etching resistance.

Meanwhile, regarding comparative MUL-4, it is conjectured that the amount of the carbon component contained in the metal-containing film was large, possibly because the polymer (R-1) was used as the crosslinking agent (B), and dry etching resistance was degraded.

In Comparative Example 3-9, the resin (R-5), which is usable as an organic underlayer film, was evaluated, and the metal-containing film had insufficient dry etching resistance.

### [Patterning Process]

Each of the above compositions (MUL-1 to -17) for forming a metal-containing film was respectively applied onto an SiO₂ wafer substrate having a trench pattern (trench width: 10 um, trench depth: 0.10 µm), and baked at 350°C for 60 seconds in the atmosphere to form a metal-containing film having a thickness of 80 nm. An organic underlayer film composition (SOC-1) was applied thereto, followed by baking at 350°C for 60 seconds to form an organic underlayer film having a thickness of 150 nm. A silicon-containing resist middle layer film material (SOG-1) was applied thereto, followed by baking at 220°C for 60 seconds to form a silicon-containing resist middle layer film (hereinafter, also referred to as a resist middle layer film) having a thickness of 30 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

As the coating-type organic underlayer film composition (SOC-1), a coating-type resist underlayer film composition (SOC-1) was prepared by dissolving a polymer represented by the organic underlayer film polymer (SOP1) in an organic solvent containing 0.1 mass% of FC-4430 (available from Sumitomo 3M Limited) in the proportion shown in Table 7; and filtering the solution through a filter made of a fluororesin and having a pore size of 0.2 µm.

**[Table 7]**

| | Organic underlayer film polymer (parts by mass) | Organic solvent (parts by mass) |
|---|---|---|
| SOC-1 | SOP1 (7) | PGMEA (93) |

The structural formula of the used organic underlayer film polymer (SOP1) is shown in Table 8.

**[Table 8]**

| Compound or polymer | Mw | Mw/Mn |
|---|---|---|
| 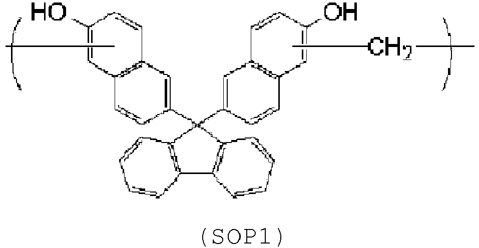 | 3, 700 | 2.82 |

The silicon-containing resist middle layer film composition (SOG-1) was prepared by dissolving a polymer represented by the ArF silicon-containing middle layer film polymer (SiP1) and a thermal crosslinking catalyst (CAT1) in an organic solvent containing 0.1 mass% of FC-4430 (available from Sumitomo 3M Limited) in the proportion shown in Table 9; and filtering the solution through a filter made of a fluororesin and having a pore size of 0.1 µm.

**[Table 9]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the used ArF silicon-containing middle layer film polymer (SiP1) and thermal crosslinking catalyst (CAT1) are shown below.

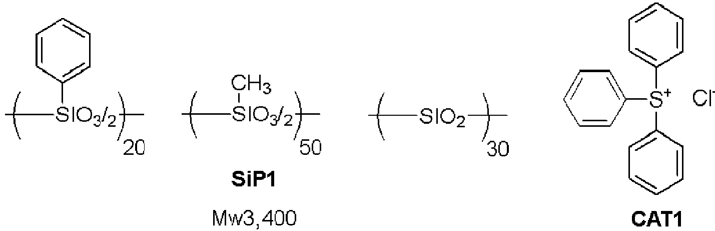

The resist upper layer film material (monolayer resist for ArF) was prepared by dissolving a polymer (RP1), an acid generator (PAG1), and a basic compound

(Amine1), each in the proportion shown in Table 10, in a solvent containing 0.1% by mass of a surfactant FC-4430 (available from Sumitomo 3M Limited), and filtering the solution through a 0.1-pm filter made of a fluororesin.

**[Table 10]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine 1 (0.8) | PGMEA (2500) |

The polymer (RP1), the acid generator (PAG1), and the basic compound (Amine1) used for the resist upper layer film material (monolayer resist for ArF) are shown below.

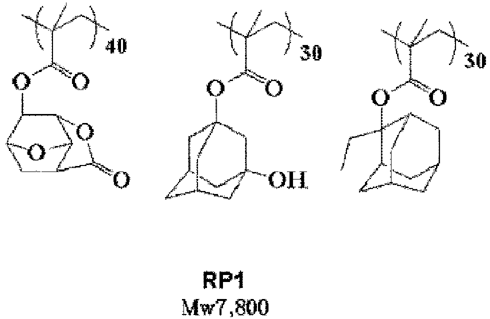

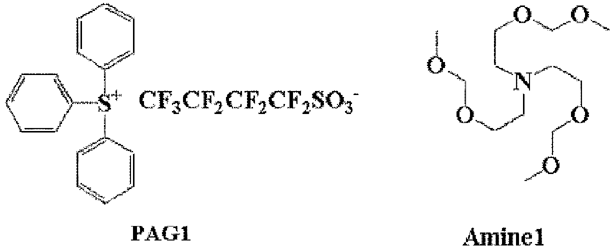

The liquid immersion top coat composition (TC-1) was prepared by dissolving a top coat polymer (PP1) in an organic solvent at the proportion shown in Table 11, and filtering the solution through a 0.1-pm filter made of a fluororesin.

**[Table 11]**

| | Top coat polymer (parts by mass) | Organic solvent (parts by mass) |
|---|---|---|
| TC-1 | PP1 (100) | Diisoamyl ether (2,700) |
| | | 2-methyl-1-butanol (270) |

The top coat polymer (PP1) used for the liquid immersion top coat composition (TC-1) is shown below.

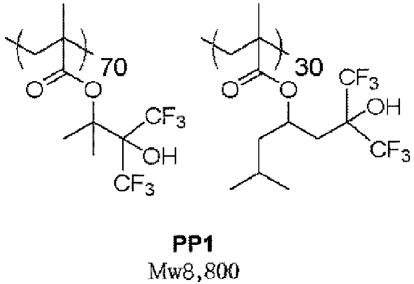

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 60 nm 1 : 1 positive line-and-space pattern (a resist upper layer film pattern).

Subsequently, the resist middle layer film was etched by dry etching while using the resist upper layer film pattern as a mask to form a resist middle layer film pattern. The organic underlayer film was then etched while using the obtained resist middle layer film pattern as a mask to form an organic underlayer film pattern. The metal-containing film was then etched while using the obtained organic underlayer film pattern as a mask to form a metal-containing film pattern. The SiO₂ film was then etched while using the obtained metal-containing film pattern as a mask. The etching was performed using an etching apparatus CE-300I manufactured by ULVAC, Inc. and under the following conditions.
Conditions in transferring resist upper layer film pattern to resist middle layer film
Conditions of dry etching with CF₄ gas
   Pressure: 1 Pa
   Antenna RF power: 100 W
   Bias RF power: 15 W
   CF₄ gas flow rate: 15 sccm
   Time: 60 sec

Conditions in transferring resist middle layer film pattern to organic underlayer film
Conditions in dry etching with O₂ gas
   Pressure: 1 Pa
   Antenna RF power: 300 W
   Bias RF power: 0 W
   O₂ gas flow rate: 25 sccm
   Time: 40 sec

Conditions in transferring organic underlayer film pattern to metal-containing film
Conditions of dry etching with Cl₂ gas
   Pressure: 1 Pa
   Antenna RF power: 320 W
   Bias RF power: 30 W
   Cl₂ gas flow rate: 25 sccm
   Time: 45 sec

Conditions in transferring metal-containing film pattern to SiO₂ film
Conditions of dry etching with CF₄ gas
   Pressure: 1 Pa
   Antenna RF power: 100 W
   Bias RF power: 15 W
   CF₄ gas flow rate: 15 sccm
   Time: 60 sec

The pattern cross section was observed with an electron microscope (S-4700) manufactured by Hitachi, Ltd. The results are shown in Table 12.

**[Table 12]**

| Example | Composition for forming metal-containing film | Pattern profile after etching for transferring to substrate |
|---|---|---|
| Example 4-1 | MUL-1 | Vertical profile |
| Example 4-2 | MUL-2 | Vertical profile |
| Example 4-3 | MUL-3 | Vertical profile |
| Example 4-4 | MUL-4 | Vertical profile |
| Example 4-5 | MUL-5 | Vertical profile |
| Example 4-6 | MUL-6 | Vertical profile |
| Example 4-7 | MUL-7 | Vertical profile |
| Example 4-8 | MUL-8 | Vertical profile |
| Example 4-9 | MUL-9 | Vertical profile |
| Example 4-10 | MUL-10 | Vertical profile |
| Example 4-11 | MUL-11 | Vertical profile |
| Example 4-12 | MUL-12 | Vertical profile |
| Example 4-13 | MUL-13 | Vertical profile |
| Example 4-14 | MUL-14 | Vertical profile |
| Example 4-15 | MUL-15 | Vertical profile |
| Example 4-16 | MUL-16 | Vertical profile |
| Example 4-17 | MUL-17 | Vertical profile |

As shown in Table 12, in Examples 4-1 to 4-17, where the inventive compositions (MUL-1 to -17) for forming a metal-containing film were used, the resist upper layer film pattern was successfully transferred to the substrate in the end in every case. Thus, it was confirmed that the inventive composition for forming a metal-containing film can be used suitably for fine processing using a multilayer resist method.

### [SOC Pattern Inversion Method]

The coating-type resist underlayer film composition (SOC-1) was applied as a resist underlayer film onto a silicon wafer substrate on which an SiO₂ film was formed, and was then baked at 350°C for 60 seconds to form a resist underlayer film having a thickness of 120 nm. A silicon-containing resist middle layer film composition (SOG-1) was applied thereto, followed by baking at 220°C for 60 seconds to form a resist middle layer film having a thickness of 30 nm. Then, a monolayer resist for ArF as a resist upper layer film composition was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The organic underlayer film composition (SOC-1), the silicon-containing resist middle layer film composition (SOG-1), the resist upper layer film composition (monolayer resist for ArF), and the liquid immersion top coat composition (TC-1) on the photoresist film were made of the same composition as that used in the patterning process (Example 4).

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass of an aqueous tetramethylammonium hydroxide (TMAH) solution for 30 seconds, thereby obtaining a 60 nm 1:1 positive line-and-space pattern (resist upper layer film pattern).

Then, the resist middle layer film was etched by dry etching while using the resist upper layer film pattern as a mask and using an etching apparatus Telius manufactured by Tokyo Electron Ltd. to form a hard mask pattern. Then, a resist underlayer film (SOC-1) was etched while using the obtained hard mask pattern as a mask to form a SOC-1 film pattern. The etching conditions were as follows.

Conditions in transferring resist upper layer film pattern to resist middle layer film
Chamber pressure: 50 mT
RF power (upper portion): 500 W
RF power (lower portion): 300 W
CF₄ gas flow rate: 150 sccm
CHF₃ gas flow rate: 50 sccm
Time: 20 sec

Conditions in transferring hard mask pattern to resist underlayer film
Chamber pressure: 10 mT
RF power (upper portion): 1,000 W
RF power (lower portion): 300 W
CO₂ gas flow rate: 150 sccm
CO gas flow rate: 50 sccm
N₂ gas flow rate: 50 sccm
H₂ gas flow rate: 150 sccm
Time: 100 sec

Next, each of the compositions (MUL-1 to -17 and comparative MUL-1 and -4 to -6) for forming a metal-containing film was respectively applied onto the obtained SOC-1 film pattern, followed by baking in the atmosphere at 350°C for 60 seconds to form a metal-containing film having a thickness of 80 nm. Thereafter, the metal-containing film covering the SOC-1 film pattern was etched to expose the upper surface of the SOC-1 film pattern. The resist middle layer film remaining on the surface of the SOC-1 film pattern with the exposed upper surface was removed by etching, then the exposed SOC-1 film pattern was removed by etching to invert the above pattern onto the metal-containing film, and the SiO₂ film was etched while using the obtained metal-containing film pattern as a mask. As a Comparative Example (Comparative Example 5-5), etching of the SiO₂ film was performed while using the SOC-1 film pattern as a mask without using the composition for forming a metal-containing film. The etching conditions were as follows.

Conditions in etching back metal-containing film (exposure of SOC-1 film pattern)
Pressure: 1 Pa
Antenna RF power: 320 W
Bias RF power: 30 W
Cl₂ gas flow rate: 25 sccm
Time: 20 sec

Removal of resist middle layer film remaining on SOC-1 film pattern
Conditions of dry etching with CF₄ gas
Pressure: 1 Pa
Antenna RF power: 100 W
Bias RF power: 15 W
CF₄ gas flow rate: 15 sccm
Time: 45 sec

Removal of SOC-1 film pattern
Conditions of dry etching with O₂ gas
Pressure: 1 Pa
Antenna RF power: 300 W
Bias RF power: 0 W
O₂ gas flow rate: 25 sccm
Time: 35 sec

Conditions in transferring metal-containing film pattern to SiO₂ film
Conditions of dry etching with CF₄ gas
Pressure: 1 Pa
Antenna RF power: 100 W
Bias RF power: 15 W
CF₄ gas flow rate: 15 sccm
Time: 60 sec

Comparative Example 5-9: conditions in transferring SOC-1 film pattern to SiO₂ film
Conditions of dry etching with CF₄ gas
Pressure: 1 Pa
Antenna RF power: 100 W
Bias RF power: 15 W
CF₄ gas flow rate: 15 sccm
Time: 60 sec

The pattern cross section was observed with an electron microscope (S-4700) manufactured by Hitachi, Ltd. The results are shown in Table 13.

**[Table 13]**

| Example | Composition for forming metal-containing film | Pattern profile after etching for transferring to substrate |
|---|---|---|
| Example 5-1 | MUL-1 | Vertical profile |
| Example 5-2 | MUL-2 | Vertical profile |
| Example 5-3 | MUL-3 | Vertical profile |
| Example 5-4 | MUL-4 | Vertical profile |
| Example 5-5 | MUL-5 | Vertical profile |
| Example 5-6 | MUL-6 | Vertical profile |
| Example 5-7 | MUL-7 | Vertical profile |
| Example 5-8 | MUL-8 | Vertical profile |
| Example 5-9 | MUL-9 | Vertical profile |
| Example 5-10 | MUL-10 | Vertical profile |
| Example 5-11 | MUL-11 | Vertical profile |
| Example 5-12 | MUL-12 | Vertical profile |
| Example 5-13 | MUL-13 | Vertical profile |
| Example 5-14 | MUL-14 | Vertical profile |
| Example 5-15 | MUL-15 | Vertical profile |
| Example 5-16 | MUL-16 | Vertical profile |
| Example 5-17 | MUL-17 | Vertical profile |
| Comparative Example 5-1 | Comparative MUL-1 | Pattern collapse |
| Comparative Example 5-2 | Comparative MUL-4 | Pattern collapse |
| Comparative Example 5-3 | Comparative MUL-5 | Pattern collapse |
| Comparative Example 5-4 | Comparative MUL-6 | Pattern collapse |
| Comparative Example 5-5 | SOC-1 | Pattern distortion |

As shown in Table 13, Examples 5-1 to 5-17, using the inventive compositions (MUL-1 to -17) for forming a metal-containing film, were all capable of accurately inverting the SOC-1 film pattern, and the reverse pattern was desirably transferred to the substrate in the end without pattern collapse. It was thus confirmed that the inventive composition for forming a metal-containing film can be suitably used for fine processing using the tone-reversal etching method of the multilayer resist process method. On the other hand, in Comparative Example 5-5, in which the SOC-1 film pattern was directly transferred to the SiO₂ film, the etching resistance of the SOC-1 film was insufficient, and therefore, the distortion of the pattern shape was observed. Meanwhile, in Comparative Examples 5-1 to -4, in which insufficient performance was observed in the filling property evaluation (pattern A), the space between the SOC-1 film patterns was not filled to the bottom with the metal-containing film, and therefore, it was not possible to invert the pattern, and a desirable reverse pattern could not be obtained in the end.

It was thus revealed that the inventive composition for forming a metal-containing film has both high filling and planarizing properties and dry etching resistance, and therefore, is significantly useful as a resist underlayer film composition used in the multilayer resist method and as an inverting agent used in the tone-reversal etching method, and that the inventive patterning processes using this composition are capable of forming fine patterns with high accuracy even when a body to be processed is a substrate having a step.

The present description includes the following embodiments.
[1]: A composition for forming a metal-containing film, comprising:
   (A) a metal compound containing at least one kind of metal selected from the group consisting of Ti, Zr, and Hf;
   (B) a crosslinking agent containing, per molecule, 2 or more and 4 or fewer cyclic ether structures having 2 to 13 carbon atoms; and
   (C) a solvent.
[2]: The composition for forming a metal-containing film of [1], wherein the crosslinking agent (B) has two or more epoxy groups or oxetanyl groups per molecule.
[3]: The composition for forming a metal-containing film of [1] or [2], wherein the crosslinking agent (B) is one of organic compounds represented by the following formulae (1), 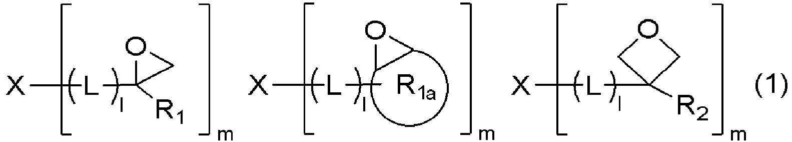 wherein X represents an m-valent organic group having 1 to 50 carbon atoms; L represents a carbonyl group or a divalent organic group having 1 to 10 carbon atoms; R₁ and R₂ each independently represent a hydrogen atom, a hydroxy group, an alkyl group having 1 to 10 carbon atoms, an aryl group having 6 to 10 carbon atoms, or an alkoxy group having 1 to 10 carbon atoms; R₁ₐ represents an alicyclic hydrocarbon group having 3 to 10 carbon atoms; "l" represents 0 or 1; and "m" represents 2 to 4.
[4]: The composition for forming a metal-containing film of [3], wherein the X in the formulae (1) is an m-valent organic group containing one or more of a quaternary carbon atom, an aromatic ring, an alicyclic hydrocarbon, or a heterocycle.
[5]: The composition for forming a metal-containing film of [3] or [4], wherein the X in the formulae (1) is one of the following structures, 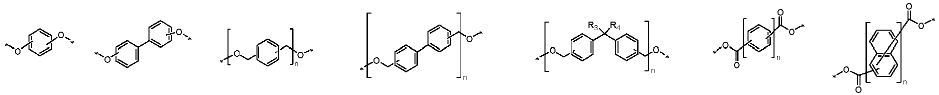 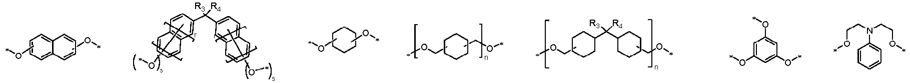 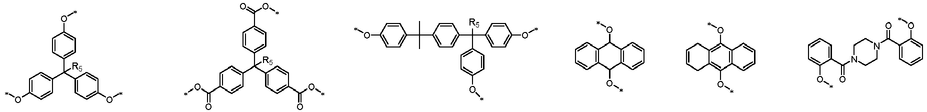 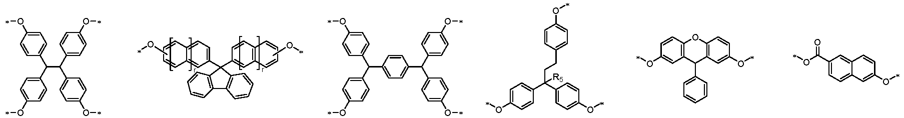 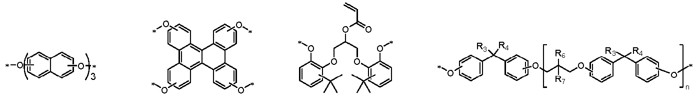 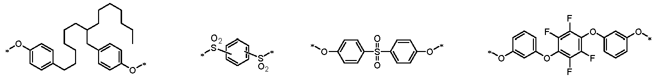 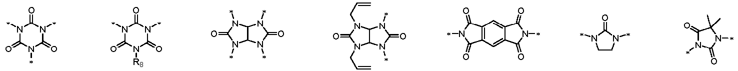 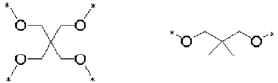 wherein "n" represents 1 to 5; "r" represents 0 or 1; "s" represents 1 or 2; R₃ and R₄ each independently represent a hydrogen atom or an alkyl group having 1 to 10 carbon atoms and optionally containing a halogen atom; R₅ represents a hydrogen atom, a hydroxy group, or an alkyl group having 1 to 10 carbon atoms; R₆ and R₇ each independently represent a hydrogen atom, a hydroxy group, or an organic group containing a group having 1 to 10 carbon atoms selected from alkyl, alkylene, and alkynyl; R₈ represents a hydrogen atom, a hydroxy group, or an organic group containing a group having 1 to 10 carbon atoms selected from alkyl, alkylene, and alkynyl; "*" represents an attachment point to the L; and a carbon atom in an aromatic ring in the formulae optionally has a substituent selected from a hydroxy group, a carboxy group, an ethenyl group, an ethynyl group, an amino group, a sulfide group, and an alkyl group having 1 to 10 carbon atoms optionally including the groups.
[6]: The composition for forming a metal-containing film of any one of [1] to [5], wherein the metal compound (A) is derived from a metal compound represented by the following formula (2),

   **LnₐMXn_{b}** **(2)**

   wherein M represents any of Ti, Zr, and Hf; Ln independently represents a monodentate ligand having 1 to 30 carbon atoms or a polydentate ligand having 1 to 30 carbon atoms; Xn independently represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.
[7]: The composition for forming a metal-containing film of [6], wherein the formula (2) has a structure of the following formula (3),

   **M(OR^{1A})₄** **(3)**

   wherein M represents Ti, Zr, or Hf; and R^{1A} represents a monovalent organic group having 1 to 20 carbon atoms.
[8]: The composition for forming a metal-containing film of [6] or [7], wherein the metal compound (A) is a reaction product between: a compound derived from the metal compound represented by the formula (2); and an organic compound having 1 to 30 carbon atoms and containing at least one crosslinking group represented by any of the following general formulae (a-1) to (a-4), (b-1) to (b-4), (c-1) to (c-3), (d-1), and (d-2), 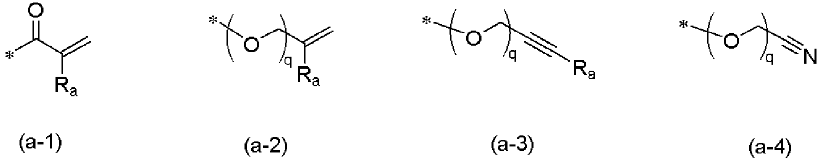 wherein Rₐ independently represents a hydrogen atom or a monovalent organic group having 1 to 10 carbon atoms, "q" represents 0 or 1, and "*" represents an attachment point, 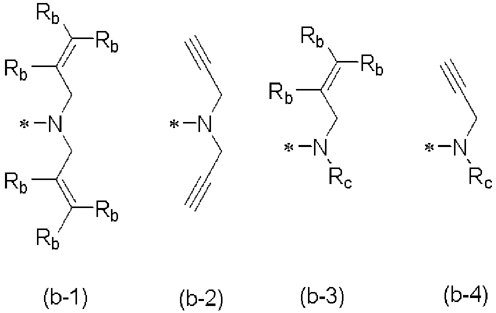 wherein R_{b}s each independently represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 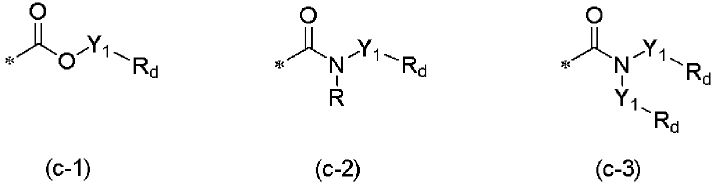 wherein Y₁ independently represents a divalent organic group having 1 to 20 carbon atoms, R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms, R_{d} independently represents an organic group whose protecting group is to be removed by an action of an acid, heat, or both to generate one or more hydroxy groups or carboxyl groups, R_{d} being represented by one of the following general formulae (c-4), and "*" represents an attachment point, 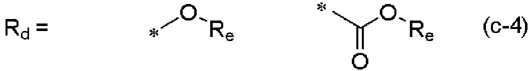 wherein Rₑ represents an organic group whose protecting group is to be removed by an action of an acid, heat, or both, and "*" represents an attachment point to Y₁, 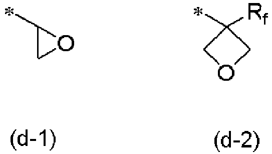 wherein R_{f} represents a hydrogen atom or an organic group having 1 to 10 carbon atoms, and "*" represents an attachment point.
[9]: The composition for forming a metal-containing film of any one of [1] to [8], wherein the crosslinking agent (B) is contained in an amount of 5 to 100 parts by mass based on 100 parts by mass of the metal compound (A) .
[10]: The composition for forming a metal-containing film of any one of [1] to [9], wherein the solvent (C) is a mixture of one or more kinds of organic solvent having a boiling point of lower than 180°C and one or more kinds of organic solvent having a boiling point of 180°C or higher.
[11]: A patterning process for forming a pattern in a substrate to be processed, comprising the steps of:
   (I-1) applying the composition for forming a metal-containing film of any one of [1] to [10] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[12]: A patterning process for forming a pattern in a substrate to be processed, comprising the steps of:
   (II-1) forming a resist underlayer film on a substrate to be processed;
   (II-2) applying the composition for forming a metal-containing film of any one of [1] to [10] onto the resist underlayer film, followed by heating to form a metal-containing film;
   (II-3) forming a resist upper layer film on the metal-containing film by using a photoresist material;
   (II-4) subjecting the resist upper layer film to pattern exposure and then development with a developer to form a pattern in the resist upper layer film;
   (II-5) transferring the pattern to the metal-containing film by dry etching while using the resist upper layer film having the formed pattern as a mask;
   (II-6) transferring the pattern to the resist underlayer film by dry etching while using the metal-containing film having the transferred pattern as a mask; and
   (II-7) processing the substrate to be processed while using the resist underlayer film having the formed pattern as a mask to form the pattern in the substrate to be processed.
[13]: A patterning process for forming a pattern in a substrate to be processed, comprising the steps of:
   (III-1) applying the composition for forming a metal-containing film of any one of [1] to [10] onto a substrate to be processed, followed by heating to form a metal-containing film;
   (III-2) forming a silicon-containing resist middle layer film on the metal-containing film;
   (III-3) forming a resist upper layer film on the silicon-containing resist middle layer film by using a photoresist material;
   (III-4) subjecting the resist upper layer film to pattern exposure and then development with a developer to form a pattern in the resist upper layer film;
   (III-5) transferring the pattern to the silicon-containing resist middle layer film by dry etching while using the resist upper layer film having the formed pattern as a mask;
   (III-6) transferring the pattern to the metal-containing film by dry etching while using the silicon-containing resist middle layer film having the transferred pattern as a mask; and
   (III-7) processing the substrate to be processed while using the metal-containing film having the formed pattern as a mask to form the pattern in the substrate to be processed.
[14]: A patterning process for forming a pattern in a substrate to be processed, comprising the steps of:
   (IV-1) applying the composition for forming a metal-containing film of any one of [1] to [10] onto a substrate to be processed, followed by heating to form a metal-containing film;
   (IV-2) forming an inorganic hard mask middle layer film selected from a silicon oxide film, a silicon nitride film, and a silicon oxynitride film on the metal-containing film;
   (IV-3) forming an organic thin film on the inorganic hard mask middle layer film;
   (IV-4) forming a resist upper layer film on the organic thin film by using a photoresist material;
   (IV-5) subjecting the resist upper layer film to pattern exposure and then development with a developer to form a pattern in the resist upper layer film;
   (IV-6) transferring the pattern to the organic thin film and the inorganic hard mask middle layer film by dry etching while using the resist upper layer film having the formed pattern as a mask;
   (IV-7) transferring the pattern to the metal-containing film by dry etching while using the inorganic hard mask middle layer film having the transferred pattern as a mask; and
   (IV-8) processing the substrate to be processed while using the metal-containing film having the formed pattern as a mask to form the pattern in the substrate to be processed.
[15]: The patterning process of [14], wherein the inorganic hard mask middle layer film is formed by a CVD method or an ALD method.
[16]: A patterning process for forming a pattern in a substrate to be processed, comprising the steps of:
   (V-1) applying the composition for forming a metal-containing film of any one of [1] to [10] onto a substrate to be processed, followed by heating to form a metal-containing film;
   (V-2) forming an organic middle layer film on the metal-containing film;
   (V-3) forming a silicon-containing resist middle layer film or a combination of an organic thin film and an inorganic hard mask middle layer film selected from a silicon oxide film, a silicon nitride film, and a silicon oxynitride film on the organic middle layer film;
   (V-4) forming a resist upper layer film on the silicon-containing resist middle layer film or the organic thin film by using a photoresist material;
   (V-5) subjecting the resist upper layer film to pattern exposure and then development with a developer to form a pattern in the resist upper layer film;
   (V-6) transferring the pattern to the silicon-containing resist middle layer film or the organic thin film and the inorganic hard mask middle layer film by dry etching while using the resist upper layer film having the formed pattern as a mask;
   (V-7) transferring the pattern to the organic middle layer film by dry etching while using the silicon-containing resist middle layer film or the inorganic hard mask middle layer film having the transferred pattern as a mask;
   (V-8) transferring the pattern to the metal-containing film by dry etching while using the organic middle layer film as a mask; and
   (V-9) processing the substrate to be processed while using the metal-containing film having the formed pattern as a mask to form the pattern in the substrate to be processed.
[17]: A tone-reversal patterning process for forming a pattern in a substrate to be processed, comprising the steps of:
   (VI-1) forming a resist underlayer film on a substrate to be processed;
   (VI-2) forming a silicon-containing resist middle layer film or a combination of an organic thin film and an inorganic hard mask middle layer film selected from a silicon oxide film, a silicon nitride film, and a silicon oxynitride film on the resist underlayer film;
   (VI-3) forming a resist upper layer film on the silicon-containing resist middle layer film or the combination of the inorganic hard mask middle layer film and the organic thin film by using a photoresist material;
   (VI-4) subjecting the resist upper layer film to pattern exposure and then development with a developer to form a pattern in the resist upper layer film;
   (VI-5) transferring the pattern to the silicon-containing resist middle layer film or the organic thin film and the inorganic hard mask middle layer film by dry etching while using the resist upper layer film having the formed pattern as a mask;
   (VI-6) transferring the pattern to the resist underlayer film by dry etching while using the silicon-containing resist middle layer film or the inorganic hard mask middle layer film having the transferred pattern as a mask;
   (VI-7) applying the composition for forming a metal-containing film of any one of [1] to [10] onto the resist underlayer film having the formed pattern, followed by heating to cover the resist underlayer film with a metal-containing film, thereby filling a space between the resist underlayer film patterns with the metal-containing film;
   (VI-8) etching back the metal-containing film covering the resist underlayer film having the formed pattern by a chemical stripper or dry etching to expose an upper surface of the resist underlayer film having the formed pattern;
   (VI-9) removing the silicon-containing resist middle layer film or the inorganic hard mask middle layer film remaining on the upper surface of the resist underlayer film by dry etching;
   (VI-10) removing, by dry etching, the resist underlayer film having the formed pattern with an exposed surface to form a reverse pattern of an original pattern on the metal-containing film; and
   (VI-11) processing the substrate to be processed while using the metal-containing film having the formed reverse pattern as a mask to form the reverse pattern in the substrate to be processed.
[18]: The patterning process of [16], wherein the inorganic hard mask middle layer film is formed by a CVD method or an ALD method.
[19]: The tone-reversal patterning process of [17], wherein the inorganic hard mask middle layer film is formed by a CVD method or an ALD method.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming a metal-containing film, comprising:
(A) a metal compound containing at least one kind of metal selected from the group consisting of Ti, Zr, and Hf;
(B) a crosslinking agent containing, per molecule, 2 or more and 4 or fewer cyclic ether structures having 2 to 13 carbon atoms; and
(C) a solvent.

2. The composition for forming a metal-containing film according to claim 1, wherein the crosslinking agent (B) has two or more epoxy groups or oxetanyl groups per molecule.

3. The composition for forming a metal-containing film according to claim 1 or claim 2, wherein the crosslinking agent (B) is one of organic compounds represented by the following formulae (1), 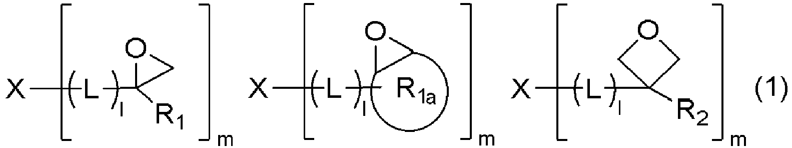 wherein X represents an m-valent organic group having 1 to 50 carbon atoms; L represents a carbonyl group or a divalent organic group having 1 to 10 carbon atoms; R₁ and R₂ each independently represent a hydrogen atom, a hydroxy group, an alkyl group having 1 to 10 carbon atoms, an aryl group having 6 to 10 carbon atoms, or an alkoxy group having 1 to 10 carbon atoms; R₁ₐ represents an alicyclic hydrocarbon group having 3 to 10 carbon atoms; "l" represents 0 or 1; and "m" represents 2 to 4.

4. The composition for forming a metal-containing film according to claim 3, wherein the X in the formulae (1) is an m-valent organic group containing one or more of a quaternary carbon atom, an aromatic ring, an alicyclic hydrocarbon, or a heterocycle.

5. The composition for forming a metal-containing film according to claim 3 or claim 4, wherein the X in the formulae (1) is one of the following structures, 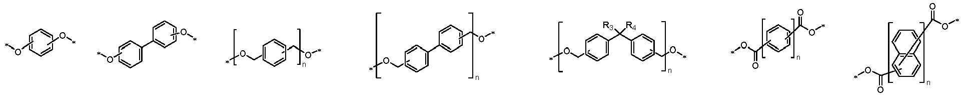 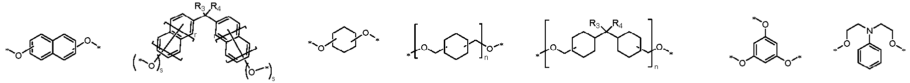 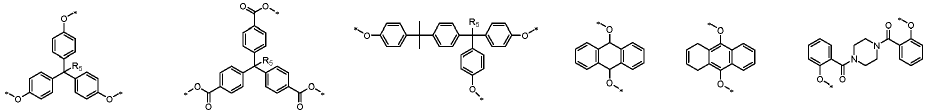 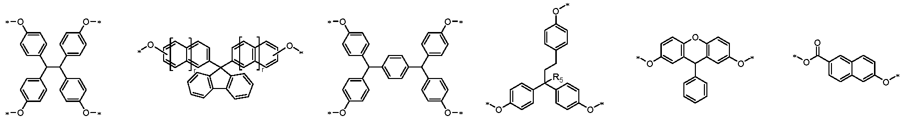 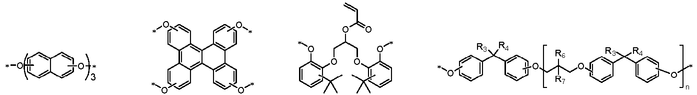 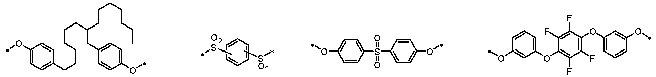 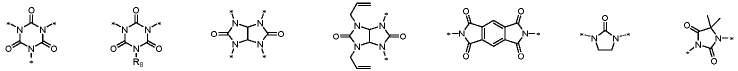 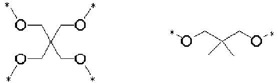 wherein "n" represents 1 to 5; "r" represents 0 or 1; "s" represents 1 or 2; R₃ and R₄ each independently represent a hydrogen atom or an alkyl group having 1 to 10 carbon atoms and optionally containing a halogen atom; R₅ represents a hydrogen atom, a hydroxy group, or an alkyl group having 1 to 10 carbon atoms; R₆ and R₇ each independently represent a hydrogen atom, a hydroxy group, or an organic group containing a group having 1 to 10 carbon atoms selected from alkyl, alkylene, and alkynyl; R₈ represents a hydrogen atom, a hydroxy group, or an organic group containing a group having 1 to 10 carbon atoms selected from alkyl, alkylene, and alkynyl; "*" represents an attachment point to the L; and a carbon atom in an aromatic ring in the formulae optionally has a substituent selected from a hydroxy group, a carboxy group, an ethenyl group, an ethynyl group, an amino group, a sulfide group, and an alkyl group having 1 to 10 carbon atoms optionally including the groups.

6. The composition for forming a metal-containing film according to any one of claims 1 to 5, wherein the metal compound (A) is derived from a metal compound represented by the following formula (2),
LnₐMXn_{b} (2)
wherein M represents any of Ti, Zr, and Hf; Ln independently represents a monodentate ligand having 1 to 30 carbon atoms or a polydentate ligand having 1 to 30 carbon atoms; Xn independently represents a hydrolysable group selected from a halogen atom, an alkoxy group, a carboxylate group, an acyloxy group, and -NR^{a}R^{b}; R^{a} and R^{b} each independently represent a hydrogen atom or a monovalent organic group having 1 to 20 carbon atoms; and a + b = 4, "a" and "b" each representing an integer of 0 to 4.

7. The composition for forming a metal-containing film according to claim 6, wherein the formula (2) has a structure of the following formula (3),
**M(OR^{1A})₄** **(3)**
wherein M represents Ti, Zr, or Hf; and R^{1A} represents a monovalent organic group having 1 to 20 carbon atoms.

8. The composition for forming a metal-containing film according to claim 6 or claim 7, wherein the metal compound (A) is a reaction product between: a compound derived from the metal compound represented by the formula (2); and an organic compound having 1 to 30 carbon atoms and containing at least one crosslinking group represented by any of the following general formulae (a-1) to (a-4), (b-1) to (b-4), (c-1) to (c-3), (d-1), and (d-2), 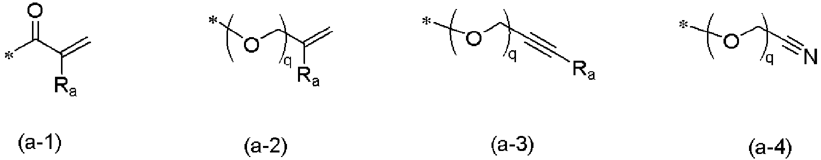 wherein Rₐ independently represents a hydrogen atom or a monovalent organic group having 1 to 10 carbon atoms, "q" represents 0 or 1, and "*" represents an attachment point, 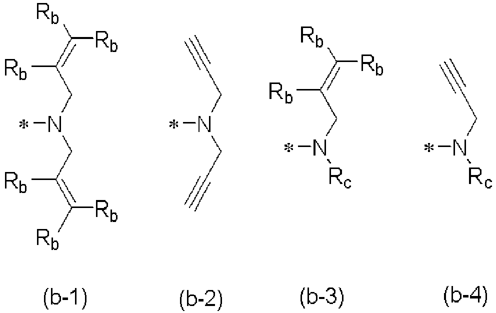 wherein R_{b}s each independently represent a hydrogen atom or a methyl group and are identical to or different from each other in a single formula, R_{c} represents a hydrogen atom, a substituted or unsubstituted, saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 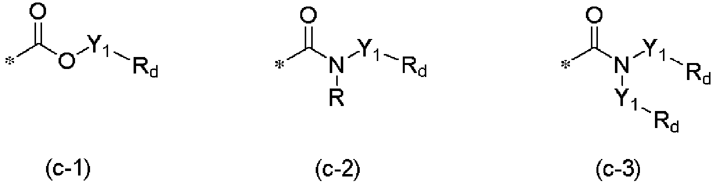 wherein Y₁ independently represents a divalent organic group having 1 to 20 carbon atoms, R represents a hydrogen atom, a substituted or unsubstituted saturated monovalent organic group having 1 to 20 carbon atoms, a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms, R_{d} independently represents an organic group whose protecting group is to be removed by an action of an acid, heat, or both to generate one or more hydroxy groups or carboxyl groups, R_{d} being represented by one of the following general formulae (c-4), and "*" represents an attachment point, 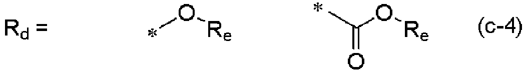 wherein Rₑ represents an organic group whose protecting group is to be removed by an action of an acid, heat, or both, and "*" represents an attachment point to Y₁, 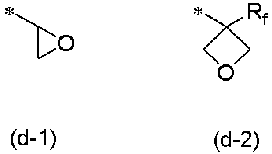 wherein R_{f} represents a hydrogen atom or an organic group having 1 to 10 carbon atoms, and "*" represents an attachment point.

9. The composition for forming a metal-containing film according to any one of claims 1 to 8, wherein the crosslinking agent (B) is contained in an amount of 5 to 100 parts by mass based on 100 parts by mass of the metal compound (A).

10. The composition for forming a metal-containing film according to any one of claims 1 to 9, wherein the solvent (C) is a mixture of one or more kinds of organic solvent having a boiling point of lower than 180°C and one or more kinds of organic solvent having a boiling point of 180°C or higher.

11. A patterning process for forming a pattern in a substrate to be processed, comprising the steps of:
11A)
(I-1) applying the composition for forming a metal-containing film according to any one of claims 1 to 10 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed; or
11B)
(II-1) forming a resist underlayer film on a substrate to be processed;
(II-2) applying the composition for forming a metal-containing film according to any one of claims 1 to 10 onto the resist underlayer film, followed by heating to form a metal-containing film;
(II-3) forming a resist upper layer film on the metal-containing film by using a photoresist material;
(II-4) subjecting the resist upper layer film to pattern exposure and then development with a developer to form a pattern in the resist upper layer film;
(II-5) transferring the pattern to the metal-containing film by dry etching while using the resist upper layer film having the formed pattern as a mask;
(II-6) transferring the pattern to the resist underlayer film by dry etching while using the metal-containing film having the transferred pattern as a mask; and
(II-7) processing the substrate to be processed while using the resist underlayer film having the formed pattern as a mask to form the pattern in the substrate to be processed; or
11C)
(III-1) applying the composition for forming a metal-containing film according to any one of claims 1 to 10 onto a substrate to be processed, followed by heating to form a metal-containing film;
(III-2) forming a silicon-containing resist middle layer film on the metal-containing film;
(III-3) forming a resist upper layer film on the silicon-containing resist middle layer film by using a photoresist material;
(III-4) subjecting the resist upper layer film to pattern exposure and then development with a developer to form a pattern in the resist upper layer film;
(III-5) transferring the pattern to the silicon-containing resist middle layer film by dry etching while using the resist upper layer film having the formed pattern as a mask;
(III-6) transferring the pattern to the metal-containing film by dry etching while using the silicon-containing resist middle layer film having the transferred pattern as a mask; and
(III-7) processing the substrate to be processed while using the metal-containing film having the formed pattern as a mask to form the pattern in the substrate to be processed.

12. A patterning process for forming a pattern in a substrate to be processed, comprising the steps of:
(IV-1) applying the composition for forming a metal-containing film according to any one of claims 1 to 10 onto a substrate to be processed, followed by heating to form a metal-containing film;
(IV-2) forming an inorganic hard mask middle layer film selected from a silicon oxide film, a silicon nitride film, and a silicon oxynitride film on the metal-containing film, optionally the inorganic hard mask middle layer film being formed by a CVD method or an ALD method;
(IV-3) forming an organic thin film on the inorganic hard mask middle layer film;
(IV-4) forming a resist upper layer film on the organic thin film by using a photoresist material;
(IV-5) subjecting the resist upper layer film to pattern exposure and then development with a developer to form a pattern in the resist upper layer film;
(IV-6) transferring the pattern to the organic thin film and the inorganic hard mask middle layer film by dry etching while using the resist upper layer film having the formed pattern as a mask;
(IV-7) transferring the pattern to the metal-containing film by dry etching while using the inorganic hard mask middle layer film having the transferred pattern as a mask; and
(IV-8) processing the substrate to be processed while using the metal-containing film having the formed pattern as a mask to form the pattern in the substrate to be processed.

13. A patterning process for forming a pattern in a substrate to be processed, comprising the steps of:
(V-1) applying the composition for forming a metal-containing film according to any one of claims 1 to 10 onto a substrate to be processed, followed by heating to form a metal-containing film;
(V-2) forming an organic middle layer film on the metal-containing film;
(V-3) forming a silicon-containing resist middle layer film or a combination of an organic thin film and an inorganic hard mask middle layer film selected from a silicon oxide film, a silicon nitride film, and a silicon oxynitride film on the organic middle layer film, optionally the inorganic hard mask middle layer film being formed by a CVD method or an ALD method;
(V-4) forming a resist upper layer film on the silicon-containing resist middle layer film or the organic thin film by using a photoresist material;
(V-5) subjecting the resist upper layer film to pattern exposure and then development with a developer to form a pattern in the resist upper layer film;
(V-6) transferring the pattern to the silicon-containing resist middle layer film or the organic thin film and the inorganic hard mask middle layer film by dry etching while using the resist upper layer film having the formed pattern as a mask;
(V-7) transferring the pattern to the organic middle layer film by dry etching while using the silicon-containing resist middle layer film or the inorganic hard mask middle layer film having the transferred pattern as a mask;
(V-8) transferring the pattern to the metal-containing film by dry etching while using the organic middle layer film as a mask; and
(V-9) processing the substrate to be processed while using the metal-containing film having the formed pattern as a mask to form the pattern in the substrate to be processed.

14. A tone-reversal patterning process for forming a pattern in a substrate to be processed, comprising the steps of:
(VI-1) forming a resist underlayer film on a substrate to be processed;
(VI-2) forming a silicon-containing resist middle layer film or a combination of an organic thin film and an inorganic hard mask middle layer film selected from a silicon oxide film, a silicon nitride film, and a silicon oxynitride film on the resist underlayer film, optionally the inorganic hard mask middle layer film being formed by a CVD method or an ALD method;
(VI-3) forming a resist upper layer film on the silicon-containing resist middle layer film or the combination of the inorganic hard mask middle layer film and the organic thin film by using a photoresist material;
(VI-4) subjecting the resist upper layer film to pattern exposure and then development with a developer to form a pattern in the resist upper layer film;
(VI-5) transferring the pattern to the silicon-containing resist middle layer film or the organic thin film and the inorganic hard mask middle layer film by dry etching while using the resist upper layer film having the formed pattern as a mask;
(VI-6) transferring the pattern to the resist underlayer film by dry etching while using the silicon-containing resist middle layer film or the inorganic hard mask middle layer film having the transferred pattern as a mask;
(VI-7) applying the composition for forming a metal-containing film according to any one of claims 1 to 10 onto the resist underlayer film having the formed pattern, followed by heating to cover the resist underlayer film with a metal-containing film, thereby filling a space between the resist underlayer film patterns with the metal-containing film;
(VI-8) etching back the metal-containing film covering the resist underlayer film having the formed pattern by a chemical stripper or dry etching to expose an upper surface of the resist underlayer film having the formed pattern;
(VI-9) removing the silicon-containing resist middle layer film or the inorganic hard mask middle layer film remaining on the upper surface of the resist underlayer film by dry etching;
(VI-10) removing, by dry etching, the resist underlayer film having the formed pattern with an exposed surface to form a reverse pattern of an original pattern on the metal-containing film; and
(VI-11) processing the substrate to be processed while using the metal-containing film having the formed reverse pattern as a mask to form the reverse pattern in the substrate to be processed.
